# EUROPEAN PATENT SPECIFICATION

(11) **EP 3 685 644 B1**
(45) Date of publication and mention of the grant of the patent: **26.10.2022**
(21) Application number: 18856006.4
(22) Date of filing: 18.09.2018
(51) Int. Cl.: H05K 9/00, G06K 19/073, G06K 7/10

(54) **RFID-CARREL**
RFID-ARBEITSKABINE
CABINE RFID

(30) Priority: 18.09.2017 FI 20177106; 20.02.2018 FI 20185156
(43) Date of publication of application: 29.07.2020
(73) Proprietor: Fentec Group Oy, 33200 Tampere (FI)
(72) Inventor: NOKKALA, Jari, 05810 Hyvinkää (FI)
(74) Representative: Berggren Oy
(86) International application number: PCT/FI2018/050678
(87) International publication number: WO 2019/053341

(56) References cited:
- EP-A1- 2 878 755
- EP-A2- 0 427 550
- US-A- 3 736 035
- US-A- 3 745 226
- US-A- 3 934 382
- US-A- 4 768 845
- US-A- 4 794 206
- US-A1- 2014 008 119
- US-A1- 2017 196 128
- US-A1- 2017 215 980
- US-B1- 6 225 554

## Description

The invention relates to a reading carrel which encloses RFID tags as defined in the preamble of claim 1.

The invention also relates to a reading carrel which encloses RFID tags as defined in claim 15.

Reading carrels for RFID tags should be as interference-free as possible for external radio frequency radiation and yet the reading sensitivity in the carrel should be as good as possible. These are conflicting objectives because increasing the reading sensitivity for RFID tags in a carrel also increases sensitivity for RFID tags external of the carrel. By merely improving the manufacturing tolerance and sealing of component parts it is difficult to improve the insulation of a carrel without also increasing significantly manufacturing/assembly costs for the carrel.

Another drawback involved in the foregoing is the fact that increasing insulation thoroughness leads to a dramatic reduction of installation speed, because the construction of insulations between a mounting frame and walls is the more laborious the better the desired insulation.

With the above prior art as a starting point, it is an objective of the invention to provide a reading carrel for RFID tags, which would be as least sensitive as possible to reading disorders caused by extra-carrel RFID tags, yet which would not require excessively tight manufacturing tolerances to be provided for the walls and the mounting frame. A further intention in the invention was to provide a reading carrel, wherein insulation between a mounting frame (base beams, vertical supports and top supports) and the walls would be simple and quick to install.

The invention relates to a reading carrel which encloses RFID tags as defined in claim 1.

More specifically, the invention relates to a reading carrel which encloses RFID tags, said reading carrel having a ceiling, a floor, at least one door, as well as walls encircling the reading carrel and including a plurality of interconnected wall elements, as well as a mounting frame for the walls and the at least one door, as well as means for reading RFID tags in the reading carrel. Thus, the reading carrel has its

- mounting frame comprising a horizontal base extending around an interior of the reading carrel and consisting of a plurality of interconnected base segments, said base being provided with a plurality of vertical supports, whereby reading means for RFID tags comprise an antenna as well as a data processing system, both of which provide a capability of reading RFID tags, wherein
each base segment as well as vertical support of the mounting frame are made of a channel beam, said channel beams having channels thereof consisting of a channel base which is provided on both sides with channel flanges directed away from the channel base, each channel flange extending in a direction transverse to that of the channel base,
each wall element of each of the walls has its lower end fitted in the channel of the mounting frame's base and, moreover, each wall has both end faces thereof fitted in the channel of the mounting frame's vertical support,
   - between at least one base segment and a bottom end of the wall element mounted thereon is fitted a radio-frequency interference suppressing seal, which is an EMC gasket, which extends co-directionally with the channel base of a channel beam comprising said base segment, whereby between at least one vertical side of a wall element mounted on said base segment and the channel flange of the channel of the channel beam comprising the vertical support mounted on the very same base segment is likewise fitted a radio-frequency interference suppressing seal, which is an EMC gasket, which extends co-directionally with the channel base of the channel beam comprising said vertical support, such that the aforesaid radio-frequency interference suppressing seal extends in a substantially continuous manner from the base segment to the channel flange of the vertical support.

In a preferred embodiment of the invention, the mounting frame further comprises a horizontal top support for the mounting frame, which is associated with a top end of the vertical supports, and which top support consists of a channel beam, having its channel made up of a channel base which is provided on both sides with channel flanges directed away from the channel base, each in a direction transverse to that of said channel base,
- one of the channel flanges of the top support is fitted with a radio-frequency interference suppressing seal, such as an EMC gasket, which extends co-directionally with the channel beam's channel base,
- each wall element of the wall has its top end fitted in the channel of the mounting frame's top support in such a way that the aforesaid radio-frequency interference suppressing seal rests respectively on a top end of the flange.

The invention relates also to a reading carrel which encloses RFID tags as defined in claim 15.

More specifically, the invention also relates to a reading carrel which encloses RFID tags, said reading carrel having a ceiling, a floor, at least one door, as well as walls encircling the reading carrel and including a plurality of interconnected wall elements, as well as a mounting frame for the walls and the at least one door, as well as means for reading RFID tags in the reading carrel, the mounting frame comprising a horizontal base extending around an interior of the reading carrel and consisting of a plurality of interconnected base segments. This base is provided with a plurality of vertical supports, each base segment as well as vertical support of the mounting frame being respectively made of a beam provided with a web which is directed upwards from the beam's horizontal plane or sideways from the beam's vertical plane and which extends in a longitudinal direction of the beam.

The wall element has its bottom end, as well as both of its end faces, provided with an elongated channel which is made up of a channel base provided on both sides thereof with channel flanges directed away from the channel base, each extending in a direction transverse to that of said channel base, whereby
- the wall element has the channel of its lower end and the channels of both end faces thereof fitted respectively on the web of a base segment in the mounting frame and on the web of a vertical support.
- between the lower end channel of each wall element of the wall and the web of a base segment of the mounting frame is fitted at least one radio-frequency interference suppressing seal, which is an EMC gasket, which extends co-directionally with the channel base, and
- between the channel of a wall element's each end face and the web of a respective vertical support is also fitted at least one radio-frequency interference suppressing seal, which is an EMC gasket, which extends in a lengthwise direction of the vertical support,
- reading means for RFID tags comprise an antenna as well as a data processing system, both of which provide a capability of reading RFID tags.

In one preferred embodiment of the invention defined in claim 15, the mounting frame further comprises a top support, which is co-directional with the base of the mounting frame and associated with a top end of the vertical supports, and said top support consists of a beam which includes a web directed downward from the beam's horizontal plane and extending co-directionally with a longitudinal direction of the top support, whereby the wall has a top end of its wall elements and/or the door frame has a top end of its head piece provided with an elongated channel, which is made up of a channel base provided on both sides thereof with channel flanges directed away from the channel base, each extending in a direction transverse to that of said channel base,
- each wall element of the wall has its top end channel and/or the door frame has the top end channel of its head piece fitted on said web of the mounting frame's top support,
- between at least one channel flange of the top end channel of each wall element of the wall and the web of the top support is fitted an elongated radio-frequency interference suppressing seal, such as an EMC gasket, which extends co-directionally with the top end channel of said wall element.

EP0427550 discloses a device for providing EMI/RFI shielding for a joint comprising a compressible, resilient sealing element and a conductive shielding element bonded to the sealing element and positioned such that the shielding element provides a direct electrical contact across the joint.

US 3736035 teaches a modular display assembly comprised of a plurality of modular elements which may be joined to define as assembly of desired configuration. The modular elements have means for receiving and supporting side panels, shelves or sliding doors.

US2017196128 discloses an enclosure for measuring RFID tags undisturbed. The RF shielding is obtained by properly sealing modular enclosure components.

US 4794206 discloses an RF shielded and acoustically insulated room having a plurality of panels fastened together to form a self-supported structure. The panels are fabricated from continuous metal sheathing and filled with acoustic insulating material. The panels are fastened togetherby joiners and compression clamps. Structural steel tubing can be fastened between the panels when additional structural strength is required.

It is a basis of the invention that a reading carrel for radio-frequency tags used for the remote identification of radio-frequency tags (i.e. so-called RFID tags) has been successfully made interference-free in terms of reading disorders caused by extra-carrel RFID tags by concentrating possible fabrication inaccuracies of the walls in a mounting frame's channel which is included in the mounting frame's base and vertical supports, as well as in the top support. Alternatively, the fabrication inaccuracies of the base are concentrated in channels included in wall elements of the walls.

Hence, it is possible to make allowances in the manufacturing accuracy of either wall elements or a mounting frame and nevertheless to achieve interference suppression considerably better than at present inside a reading carrel for RFID tags. Thereby is attained the significant benefit of being able to enhance the reading accuracy of an RFID tag reader without being exposed to reading disorders generated by RFID tags external of the reading carrel.

The concept "the seal extends in a continuous manner" is used in reference to a sealing possibly including rather minuscule voids left inside the seal, but not outright discontinuities at which the sealing would have been disrupted.

It is by using a mounting frame of the invention, including channel beams, on which can be mounted a wall element or wall elements, provided with channels in which can be fitted webs of the mounting frame, that there is obtained a structure capable of being sealed easily and with extraordinary speed; the sealing is easy to install so as to encircle the mounting frame as well as the wall elements' channels/webs.

The invention will now be described more precisely with reference to the accompanying figures.
Fig. 1A shows, in a view diagonally from above, a top support installed on a mounting frame's base.
Fig. 1B shows, in a schematic perspective view, the top support as seen from behind.
Figs. 2A and 2B show schematically two principles of channel sealing for the mounting frame's beams.
Figs. 2C-2H show schematically various sealing systems for a web present in a beam of the mounting frame and for a channel present in the wall.
Figs. 2K and 2L depict schematically assemblies made up by a web and a channel in the mounting frame's top support and walls.
Figs. 3A and 3B show, in a diagonal view from above, the way a vertical support is installed in a corner of the mounting frame's base, as well as a completed corner of the base provided with a vertical support.
Figs. 4A and 4B illustrate, in a perspective view, various vertical supports installed both on a straight section of the mounting frame's base segment and in a corner of the base.
Fig. 4C illustrates schematically the way a corner of the mounting frame's base is constructed from two base segments.
Fig. 5 shows, in a lateral view, the end face of a vertical support provided with an end face adapter for installing a vertical support on the mounting frame's base or on the mounting frame's top support.
Fig. 6 shows, in a diagonal lateral view, the way of adjusting the mounting frame's base by means of an auxiliary mounting frame.
Figs. 7A and 7B show, in a diagonal front view, a part of two different reading carrels for RFID tags.
Figs. 8A-8D illustrate, in a view from above, various mounting frame configurations for constructing an RFID-carrel.
Fig. 9 illustrates, in a view from outside, one completed reading carrel for RFID tags.

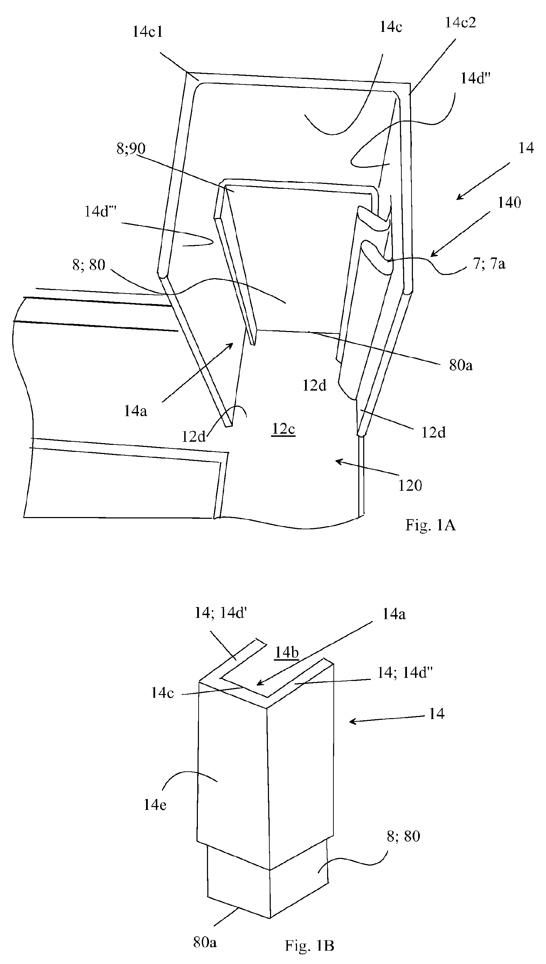

Constructions used in connection with a mounting frame 1 of the invention for a vertical support 14. a mounting frame-encircling base 12, a top support 13, a door frame support 15, and wall elements 31 of walls 3 are illustrated in figs. 1A-1B, 2AH, 2K, 2L, 3A-3B, 4A-4C, 5, as well as 6.

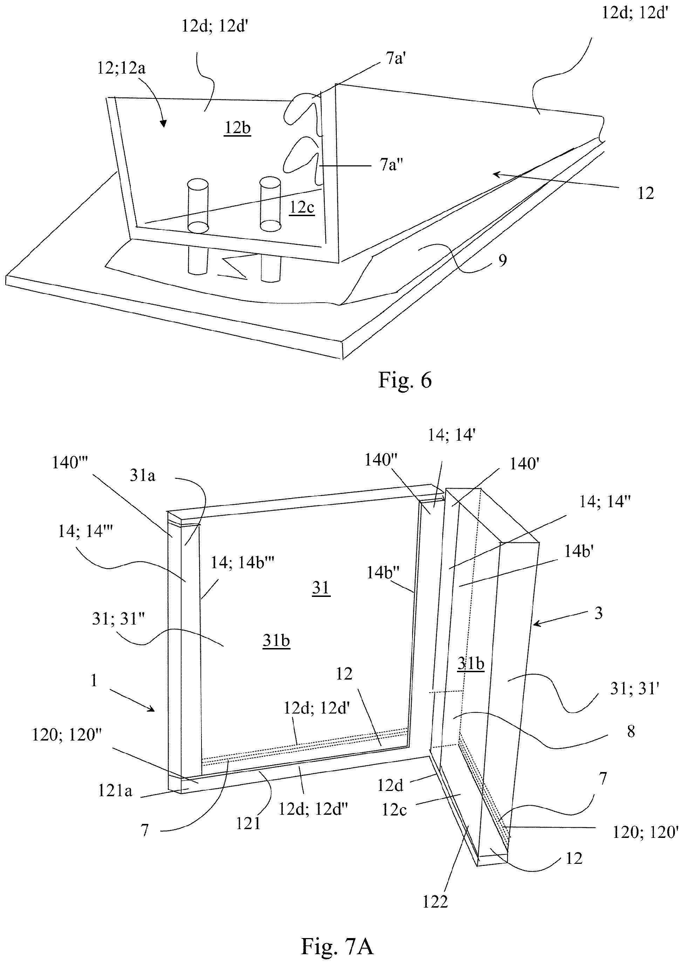

These basic constructions of the mounting frame 1 enable assembly of various reading carrels for RFID tags as depicted in figs. 7A-7B, 8A-8D, and 9.

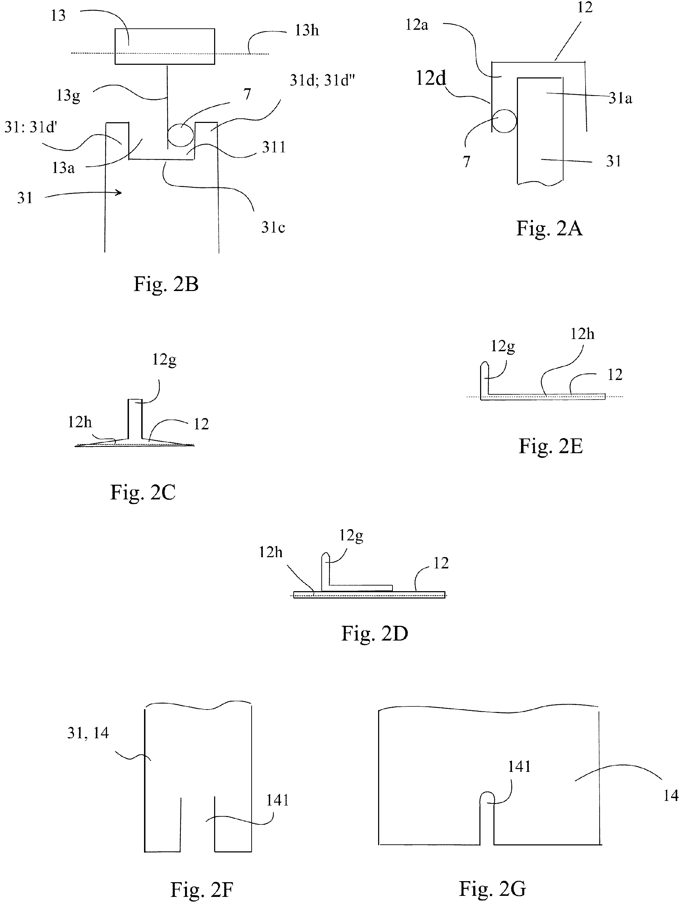

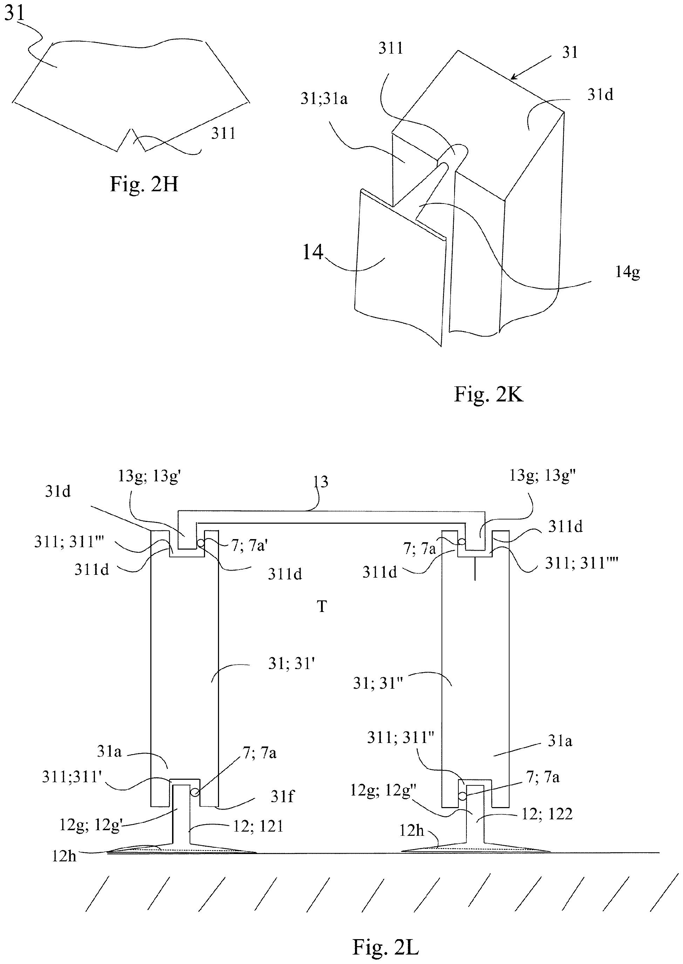

Hereinafter is first described, schematically by way of figs. 1A-1B and 2A-2H, 2K, 2L, constructions as well as sealing options for the mounting frame 1 and wall elements connected therewith.

In figs 2A and 2B is illustrated with two section views, respectively, the construction of two similar type sealings either
a) by placing a gasket 7 between a channel beam (120, 130 or 140) and a wall element 31 or
b) by placing a gasket 7 between a wall element 31 provided with a channel 311 and a web 13g extending from a beam 13 (vertical support).

The exemplary sealing visible in fig. 2A is constructed by placing the gasket 7 between a U-channel 12a of the base 12 comprising a channel beam and a bottom end of the wall element 31 fitted in this U-channel 12a. A similar type sealing can also be constructed by installing a gasket between a U-channel of the top support 13 comprising a channel beam and a top end of the wall element 31 or between a U-channel of the vertical support 14 and an end face of the wall element 31. As evident from fig. 2A, the gasket is usually placed between a bottom end of the wall element 31 adjoining the lower end face thereof and just one of the channel flanges of the U-channel in a base segment.

The exemplary sealing visible in fig. 2B is constructed between a web 13g directed downward from the beam of the top support 13 and a horizontal channel 31a extending at a top end of the wall element 31 co-directionally with the top end of the wall element 31, said horizontal channel opening upward. The top support 13 has its web 13g brought to the proximity of a channel base 31c of the horizontal channel 31a at the top end of the wall element 31. The gasket 7 is placed between a channel flange 31d; 31d" and the web 13g, the former extending upward from the horizontal channel's channel base 31c. An exactly similar type sealing can likewise be constructed between a web 12g directed upward from a base segment of the base 12 and a horizontal channel 311 included in a bottom end of the wall element 31 and opening downward, or between a web directed sideways from a vertical support 14 co-directionally with the vertical support and an end channel 311 included in an end face of the wall element 31 and opening sideways.

Fig. 1B illustrates one way of placing a gasket 7 on a channel beam 140, said channel beam 140 being then usable for constructing the sealing of fig. 2A between the channel beam 140 and the bottom end 31 of a wall element as subsequently described.

In fig. 1B is shown (in a view from behind) a channel beam 140 that can be used as a vertical support 14. From below a bottom edge of the channel beam 140 extends an end adapter 8; 80 directed downward in fig. 1B and being narrower than the rest of the beam body. The illustrated channel beam 140 is capable of being rested by way of a bottom end bearing surface 80a of its end adapter 80 against a channel base 12c of the base segment's channel beam 120 as depicted in fig. 1A.

The vertical support 14 visible in fig. 1B consists of a channel beam 140 having its U-shaped channel 14a (U-channel) made up of a channel base 14c both lengthwise sides of which are provided with a channel flange 14; 14d' and 14; 14d" pointing away from the channel base 14c. Each channel flange 14; 14d' and 14; 14d" of the vertical support 14 extends away from the channel base 14c of the U-channel 14a at an angle of about 90 degrees, whereby the plane extending by way of each channel flange 14; 14d' and 14; 14d" is transverse relative to the direction of the channel base's 14c plane.

In fig. 1A is shown a channel beam 140 of fig. 1B (vertical support 14), including a U-channel 14a. This U-channel 14a connects to the base 12 by way of an adapter 8. The adapter 8 comprises an inner adapter 8; 90 for the vertical support 14 and an end face adapter 8; 80a joining seamlessly with the inner adapter. The end face adapter 8; 80a is rested against a channel base 12c of the channel 12a in the mounting frame's base 12.

In fig. 1A, it is only along one of the two channel flanges 14d; 14d" of the vertical support 14 that, co-directionally with the channel base 14, i.e. in vertical direction, extends a continuous EMC gasket 7; 7a, which is approximately equal in length to said channel flange 14; 14d" and which conducts electricity. The EMC gasket is suitably an aluminum strip.

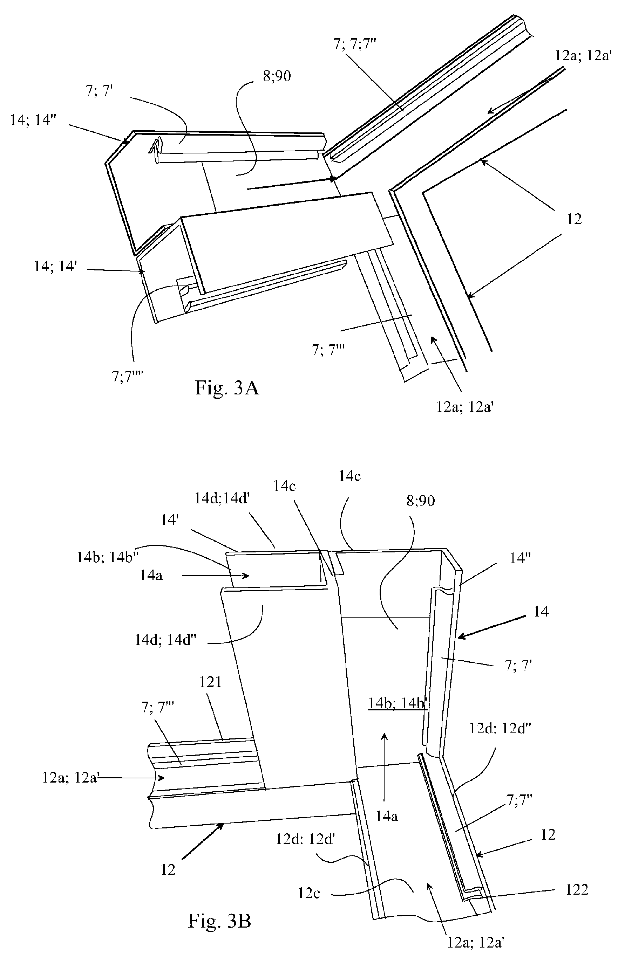

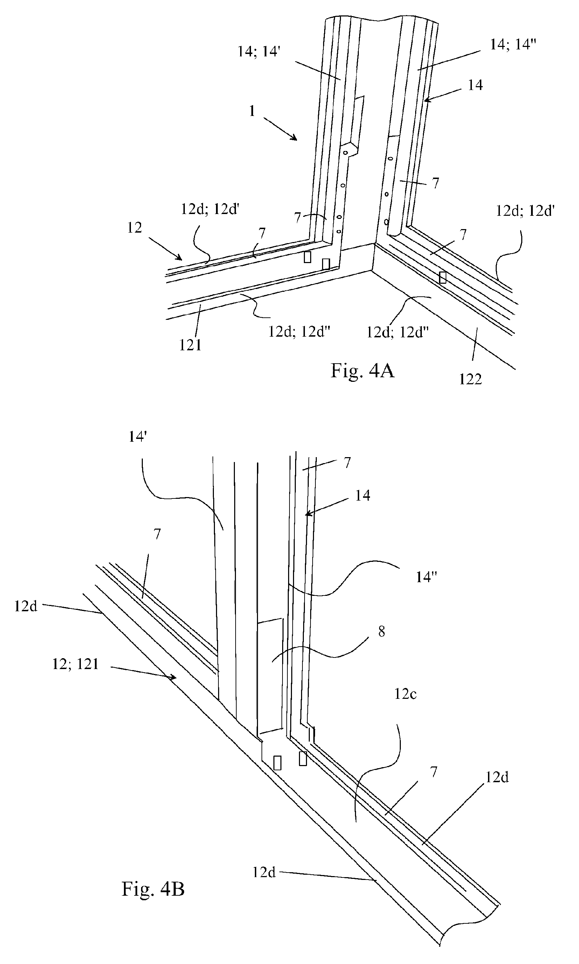

The EMC gasket has an objective of sealing, as illustrated in fig. 2A, a clearance left between a wall element 31 mountable on the vertical support 14 and a channel flange 14d of the vertical support's U-channel, such that the EMC gasket 7; 7a does not allow passage of radio-frequency radiation therethrough from inside to outside of the carrel or vice versa. As can be seen from fig. 1A, once the vertical support 14 is rested by way of the end face adapter 8; 80 against the channel base 12c of the mounting frame's base 12, the vertically directed EMC gasket extends all the way to a channel flange 12d of the base 12. On this channel flange 12d is then installed its own EMC gasket in horizontal direction. It is for the purpose of simplifying the figure that seals for the channel 12c of the base 12 are omitted from fig. 1. Gaskets 7 for the channel 12c of the base 12, and the relationship thereof with gaskets 7 of the vertical support 14, are depicted i.a. in figs. 3A-3B and 4A-4B. Thus, it is figs. 3A-3B and 4A-4B which depict more accurately an EMC gasket 7; 7a, which extends specifically along the mounting frame's base 12 co-directionally with a channel base 12c of one of its base segments, and which during installation comes into contact with the EMC gasket of the vertical support 14 (cf. fig. 1A).

As can be seen, among others, from fig. 3B, the gasket 7 thereby constitutes a continuous sealing strip 7", 7' extending from the channel 12a in a base segment of the base 12 to the channel 14a of a vertical support 14. The channel 14a of a vertical support 14 and the channel 12a of a base segment are in contact with each other by way of the channel flanges 14d", 12d' thereof, which is why the sealing strip extends from the channel flange 12d" of a base segment's channel to the channel flange 14d" of a vertical support's 14 channel. The benefit gained by such a continuous sealing strip 7", 7' is its ability to prevent radio-frequency radiation from propagating across to the opposite side in spite of minor inaccuracies in the manufacturing tolerances of a wall element 31, a base 12 or a vertical support 14 or in spite of slightly out-of-alignment assembly of the base 12 and the vertical support 14, i.e. a deviation from their conventional position normal to each other.

Figs. 2C-2E present various vertical webs 12g directed upward from a lengthwise plane 12h (horizontal plane) of a base segment of the frame 1.

Figs. 2K and 2L, on the other hand, depict schematically assemblies made up jointly by a web and a channel in segments of the mounting frame's base 12, as well as in ceiling structures (top support 13) and in a vertical support 14.

In figs. 2C-2E are shown, in schematic section views, various webs 12g directed upward from a lengthwise plane 12h (horizontal plane) of a base segment of the frame 1. The webs 12 g extend always perpendicularly to the horizontal plane 12h, which is parallel to a foundation on which the base segment is rested. A similar type web 12g may also be included in the top support 13, in which case it extends respectively from the top support and, at the same time, also from a plane of the ceiling perpendicularly downward as depicted in fig. 2B. A similar type web 12g may also be included in the vertical support 14, in which case the web is vertical and directed sideways from a vertical plane defined by the vertical support 14, towards a base segment fastened to the vertical support 14.

In figs. 2K and 2L are respectively illustrated various channels extending in a top or bottom end of the wall element 31 or in an end face of the wall element 31 (cf. fig. 2B). These can be respectively fitted with a web, an away-directed web connecting to a base segment 21, 22, 23, 24, a top support 13 or a vertical support 14, as presented above schematically in figs. 2B as well as 2C-2E.

In fig. 2K is presented how a vertical channel 311 extending in an end face of the wall element 31 can be fitted with a horizontal web 14g of the type shown in fig. 2C, which protrudes from the vertical support 14. The joint depicted in fig. 2K can be insulated by placing a seal between the web 14g and a channel flange of the channel 311 extending in an end face of the wall element 31.

Fig. 2L visualizes how a sealing constructed according to the invention is achieved in a joint which is established between vertical webs 12g, included in segments 121 and 122 of the mounting frame's 1 base 12, as well as wall elements 31; 31' and 31; 31". Each wall element 31; 31' and 31; 31" has its bottom end face 31f formed with a downward-opening channel 311; 311' and 311; 311" in which each web 12g; 12g' or 12g; 12g", directed upward from a plane of the base's segment 121, 122, is capable of being accommodated. The wall elements 31; 31' and 31; 31" are visualized having been installed, by way of the horizontal channels 311; 311' and 311; 311" included in the bottom end face 31f thereof, respectively on two webs 12g; 12g' and 12g; 12g" rising upward from a plane of the base's 12 base segment 121, 122. The gap between these webs 12g; 12g' and 12g; 12g" as well as the horizontal channels 311 in the bottom end faces 31f of the wall element 31; 31' and 31; 31" is sealed with an EMC gasket 7, which in this case is an aluminum tape/strip.

In fig. 2L is further shown an upward-opening horizontal U-channel 311; 311‴ and 311; 311"" included in a top end of each wall element 31; 31' and 31; 31", more specifically in a top side 31d of the top end. These horizontal channels 311; 311‴ and 311; 311"" at the top ends of the wall elements 31; 31' and 31; 31" are fitted with a top support 13 which has two webs 13g; 13g' or 13g; 13g", directed downward from a plane of this top support 13 (cf. also fig. 2D). Between the web 13g; 13g' or 13g; 13g", directed downward from a plane of the top support 13, and a vertical side of the horizontal channels 311; 311‴ and 311; 311"" lies a horizontally extending EMC gasket 7; 7a. The gasket 7; 7a is installed on that vertical side of a wall element's 31 horizontal channel which is closer to a reading carrel T and it extends in a continuous manner in a channel 311 of the wall element's 31 top end 31d as well as in a web 13g of the top support 13. When the channel 311 of the wall element's 31 top end 31d is fitted on the top support's 13 web 13g, the passage of radio-frequency radiation into the reading carrel T by way of the top support's channel 311 is prevented, for example from the side of an adjacent storage. Thus, the sealing strip made up of gaskets 7 extends continuously from a web 13g of the mounting frame's 1 top support 13 to a web 14g (not shown in the figure) of two side supports 14 connected to each top supports, and further to that web 12g of a base segment of the base 12 which comes into contact with these two side supports.

In figs. 3A-3B, 4A-4B is also illustrated vertical support pairs 14, 14 installed on segments of the mounting frame's 1 base 12 and having mouths 14b, 14b of the C-channel thereof opening at an angle of either 90 or 180 degrees relative to each other.

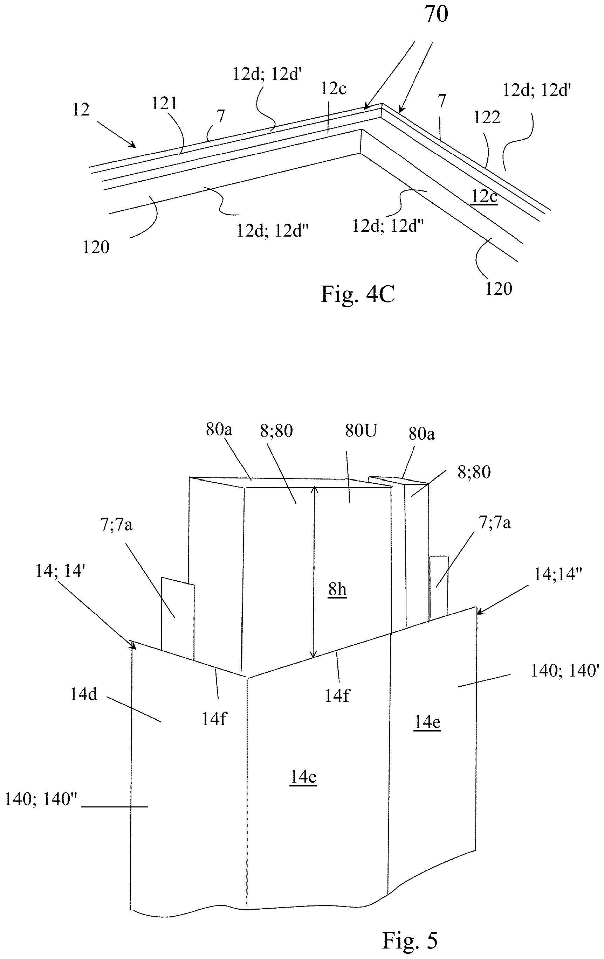

Fig. 4C, on the other hand, visualizes a corner of the mounting support's base 12, at which arrive two base segments 121, 122 at a right angle with each other.

Fig. 5 visualizes the construction of a vertical support 14 according to one preferred embodiment of the invention, having its vertical channel 14a provided with an adapter 8 for connecting said vertical support 14 to a horizontal channel 12a or 13a of the base 12 and/or the top support 13.

With these vertical support pairs 14, 14, adapters 8 of the vertical support 14, and segments of the base 12, illustrated in figs. 3A-3B, 4A-4B, 4C and 5, there is provided an ability to produce readily and quickly sealable constructions between the mounting frame 1 and the wall elements 31 and door jambs 15 installable thereon. These constructions will be described hereinafter and comprise couplings between interconnected vertical supports and base segments.

Fig. 4C visualizes how the segments 121 and 122 of the base 12 are coupled to each other in such a way that the bottom thereof extend in a common horizontal plane, yet the lengthwise directions thereof are at an angle of 90 degrees, i.e. at a right angle, relative to each other. The right angle between the base segments 121, 122 enables installation at an angle (corner) therebetween of a vertical support pair 14, 14 whose vertical channels 14a, 14a open at an angle of 90 degrees relative to each other as illustrated in figs. 3B and 4A.

A corner of the base 12, visible in fig. 4C, is assembled from two base segments 121 and 122 of the base 12 by coupling the same to each other for a 90-degree angle. Each base segment 121, 122 of the base 12, and at the same time the entire base 12 as well, is made up of a channel beam 120. The channel beam 120 has its channel 12a made up of a channel base 12c whose both lengthwise sides are provided with channel flanges 12d; 12d' and 12d; 12d" directed away from the channel base, each extending in a direction which is transverse to that of said channel base 12c. Close to an upper edge of one of the channel beam's 120 channel flanges 12d; 12d' extends a continuous elongated, strip-like gasket 7 manufactured from an electrically conductive material such as metal. The gasket 7 follows said upper edge of the channel flange 12d; 12d', extending thereby in a lengthwise direction of the channel base. The gasket 7 extends along the channel beam 120 preferably from end to end.

Figs. 3B and 4A visualize a vertical support pair 14; 14' and 14; 14" already fitted in the channels 12a of two base segments 121, 122 of the base 12, said vertical supports having mouths 14b, 14b' and 14b; 14b" thereof opening at an angle of 90 degrees relative to each other. Fig. 3A shows, on the other hand, how the vertical support pair 14; 14' and 14; 14" is mounted on the base segments 121, 122 of the base 12 present at a 90-degree angle relative to each other. The base's segments 121, 122 are coupled to each other the same way as described above in reference to fig. 4C.

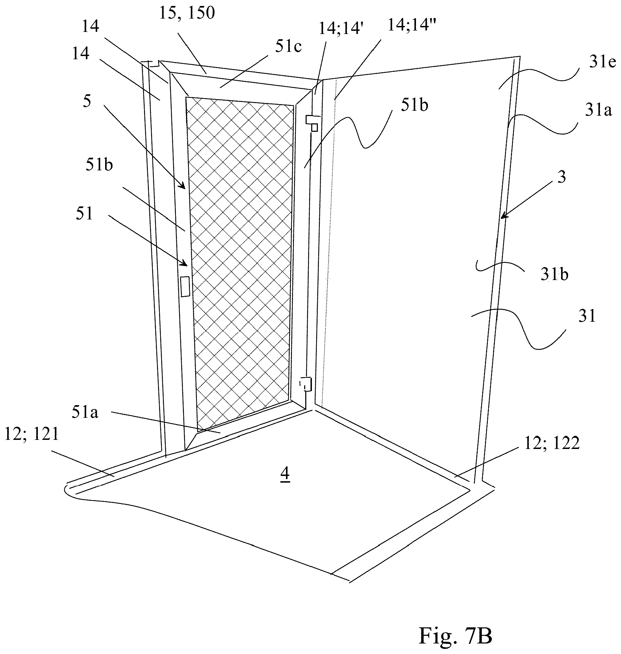

Fig. 4B reveals, on the other hand, two vertical supports 14; 14' and 14; 14" installed in a channel 12a of a single base segment 121 of the base 12, with mouths 14b, 14b thereof opening at an angle of 180 degrees relative to each other. Such a vertical support pair 14', 14" is mounted on the middle part of a base segment and can be used for example as an interim support for the installation of a door 5 on the mounting frame's base segment so as to be subsequently illustrated in fig. 7B.

The rear flanges of vertical support pairs 14; 14' and 14; 14" displayed in figs. 3A-3B as well as 4A-4B can be coupled to each other prior to installation. Each vertical support 14', 14" of the vertical support pair 14; 14' and 14; 14", made up of interconnected vertical supports and presented in figs. 3A-3B as well as 4A-4B, consists of a channel beam 140 identical to that described above in reference to figs. 1A and 1B. The construction of a channel beam 120 of the base segments displayed in figs. 3A-3B as well as 4A-4B, on the other hand, is identical to what has been more precisely described in reference to fig. 4C.

Fig. 5 reveals the construction of a vertical support 14 according to one preferred embodiment of the invention, said vertical support being provided with an adapter for coupling the vertical support 14 to a base 12 and/or a top support 13. This has been demonstrated with two identical, longitudinally interconnected vertical supports 14; 14' and 14; 14" visible in fig. 5, each of which is made up of a channel beam 140. The construction of channel beams 140; 140' and 140; 140" is identical to what has been described earlier in connection with fig. 1A. Above a top edge of the lower part (or upper part) or a top end face 14f (of the lower part) of each channel beam 140; 14' and 140; 140" 140 rises an end face adapter 80 visible in the figure. Said vertical supports 14; 14' and 14; 14" are connected to each other the same way as those illustrated in figs. 3A-3B as well as 4A-4B, whereby the first vertical support 14; 14' has the rear wall of its channel flange 14d coupled to the rear wall of the second vertical support's 14; 14" channel base 14c.

The end face adapter 80 is part of an adapter 8 already fixed to a channel 14a of the vertical support 14, whereby the vertical support 14 is attachable to the base 12. The adapter 8 includes an inner adapter, as well as the end face adapter 80 shown in the figure. The end face adapter protrudes from outer edges 14f, 14f of the end faces of a channel base 14c and channel flanges 14d, 14d of the channel 14a of a channel beam 140 employed as the vertical support 14 co-directionally with the channel 14a over a certain distance (protruding distance) 80h. The end face adapter 8; 80 has its protruding distance 80h matching the depth of a channel 12a of the base 12 or a channel 13a of the top support 13, i.e., in practice, the vertical width of channel flanges 12d or 13d of the base's channel 12a or the top support's channel 13a. Here, the vertical support 14 has the length of its EMC gasket 7; 7a slightly exceeding that of the channel flanges 14d and channel base 14c of the vertical support 14. Hence, the gasket 7; 7a extends from a top edge (outer edge) 14f of the vertical support's 14 channel flange 14d to about a midpoint of the length (protruding distance) 80h of the end face adapter 80.

The vertical support 14 is mounted on a channel beam 120 of the base 12 by means of said adapter 8 in such a way that the end face adapter 80 has a bearing surface 80a of its end face rested against a channel base 12c of the base's channel 12a or against a channel base 13c of the top support's 13 channel 13a. Hence, the gasket 7; 7a, which is co-directional with a channel flange 14d of the vertical support 14, extends to a gasket 7 extending along a flange 12d or 13d of the base 12 or the top support 13 and following a top edge of the flange. Thus, the gasket 7; 7a has its length designed to be such that it extends all the way of a horizontal gasket 7 extending along a channel flange 12d or 13d of the base's 12 or top support's 13 channel beam 120 or 130.

Provided that the vertical support 14 has top and bottom ends of its channel beam 140 fitted with an end face support 80, 80, there will be a capability of resting a lower end face adapter 80 of the channel beam 140 against a channel base 12c of the base's 12 base segment 12a and of resting an upper top adapter 80 against a channel 13c of the top support's 13 channel 13a. Thereby, the vertical support 14 has its gasket 7; 7a, which is co-directional with the channel flange 14d, extending all the way to a gasket 7 extending along a flange 12d the base 12 as well as along a channel flange 13d of the top support 13 and following a top edge of the flange 12d and 13d. This way is provided a continuous sealing strip 70 from base segments of the base 12 along a vertical support 14 and further to a top support 13.

Fig. 6 displays an arrangement used for leveling the base 12. There, underneath a bottom of the mounting frame's base 12 is installed an auxiliary mounting frame 9 such as a rigid metal foil. This is followed by adjusting orientation of the mounting frame's base with respect to the ground or the foundation of a building with screws bearing against the auxiliary mounting frame as well as with a spring retained between the screws.

In figs. 7A and 7B there is respectively displayed two wall elements 31; 31' and 31; 31" for the wall 3 (fig. 7A) as well as a wall element 31 and a door 5 (fig. 7B), mounted on a pair of vertical supports 14; 14' and 14; 14" present in a corner formed by segments 121 and 122 of the base 12.

Hence, the vertical supports 14; 14' and 14; 14" made up of channel beams 140 have mouths thereof opening at an angle of 90 degrees away from each other co-directionally with a channel base 12c, 12c of the base segments 121 and 122 of the base 12 likewise made up of channel beams. This structure, composed of interconnected pairs of vertical supports 14; 14' and 14; 14" and base segments 121, 122 of the base 12, is similar to what has been displayed earlier in figs. 1A-1B, 3B and 4B, 4C. Thus, each vertical support of the pair of vertical supports 14; 14' and 14; 14" consists of interconnected channel beams 140', 140" whose construction is similar to what has been described earlier for example in reference to figs. 1A and 1B. Likewise, each of both base segments 121 as well as 122 of the base consists of channel beams 120 whose construction is similar to what has been described earlier for example in reference to figs. 1A and 1B.

In fig. 7A, each wall element 31; 31' and 31; 31" is coupled to the mounting frame 1, which includes not only the aforesaid pair of vertical supports 14; 14' and 14; 14" present at an angle or corner formed by the base segments 121, 122 but also a vertical support 14, which is coupled to an end face of each base segment 121 and 122 and which has its mouth 14b turned perpendicularly towards a vertical support present at the other end of the base segment. In the exemplary figure 7A is only shown, seen in a direction from the pair of vertical supports 14; 14' and 14; 14", a third vertical support 14; 14‴ coupled to one end face 121a of the base segment 121. The vertical support 14; 14‴ consists of a channel beam 140‴ whose construction is similar to what has been described earlier for example in reference to figs. 1A and 1B. The vertical support 14‴ has its mouth 14b‴ turned directly towards the vertical support 14; 14' present at an opposite end of the base's 12 segment 121.

In addition, the mounting frame 1 comprises a horizontal top support, not shown, which connects to top ends of the vertical supports 14; 14' and 14; 14" via an end face adapter (not shown in the figures) present at the vertical supports' top end.

Each channel beam 120; 120' and 120; 120" making up the base segments 121 and 122 for the base 12 is fitted with a radio-frequency interference suppressing gasekt 7, preferably an EMC gasket. The gasket 7 extends co-directionally (in horizontal direction) with a channel base of the relevant channel beam 120' and 120" along the channel beam 120' and 120" from end to end. One of the channel flanges (12d, 14d) of a channel (12a, 14a) in a channel beam 140; 140', 140" and 140‴ making up each vertical support 14; 14', 14" and 14‴ is also fitted with a radio-frequency interference suppressing gasket 7 such as an EMC gasket. The gasket 7 extends co-directionally with a channel base 12c, 14c of each vertical support 140; 140', 140" and 140"', i.e. in vertical direction, extending to end face adapters (not shown in the figure) present at bottom and top ends of the channel beam 140; 140', 140" and 140‴ making up each vertical support 14; 14', 14" and 14‴ as illustrated in fig. 5.

The vertical supports 14; 14', 14" and 14‴ are mounted on the channel beams 120; 120' and 120; 120" of base segments of the base 12 by means of end face adapters 80 included in bottom ends of the vertical supports 14; 14', 14" and 14‴. In addition, each vertical support 14; 14', 14" and 14‴ is coupled to horizontal top supports, not shown in fig. 7A, by means of an end face adapter (not shown in the figures) included in a top end of each vertical support. The vertical supports 14; 14', 14" and 14‴ are also coupled, as depicted in fig. 5, i.e. by means of an end face adapter 80, to the channel beams 120; 120' and 120; 120" the base's 12 base segments and to said top supports. Thus, the gasket 7, which is co-directional with a channel flange 14d of each vertical support 14; 14', 14" and 14‴, extends all the way to a gasket 7 which extends along a flange 12d or 13d of the base 12 or the top support 13, following a top edge of the flange 12d or 13d. The gasket 7; 7a is designed in such a way in terms of its length that it extends all the way to an elongated gasket 7 extending along a channel beam 120 of the base's base segment or a channel beam 130 of the top support 13.

Accordingly, the gasket 7, which is co-directional with a channel flange 14d of each vertical support 14; 14', 14" and 14‴, extends all the way to a seal which extends along a flange 12d of the base's 12 base segment 121 or 122, as well as along a channel flange 13d of the top support 13, following a top edge of the channel flange. Thereby is provided a continuous sealing strip, which extends from each base segment 121, 122 of the base to each vertical support 14; 14', 14" and 14‴ mounted on these base segments, and further to the top support 13.

Each wall element 31; 31' and 31; 31" has its bottom end now fitted in a channel 12c of the base segment 121 or 122 included in the mounting frame's 1 base 12. On the other hand, each wall element 31; 31' and 31; 31" has both of its end faces, and side faces adjoining these end faces, fitted in channels 14a of the mounting frame's vertical supports 14; 14', 14" and 14"'. Each wall element 31; 31' and 31; 31" has its top end face fitted in top supports (not shown in the figures) following the base segments 121, 122. Thereby, the radio-frequency interference suppressing seals 7 make up a continuous sealing strip, which extends from each base segment 121, 122 of the base to each vertical support 14; 14', 14" and 14‴ and further to the top support 13. This sealing strip is also supported on a bottom end of each wall element 31, on a side face adjoining each vertical side, and on a top end of the wall element, thereby making up a continuous sealing strip encircling an outer edge of the wall element's front side.

Fig. 7B illustrates part of a mounting frame 1 of the invention provided with a door 5. The mounting frame 1 includes first of all two base segments 121, 122, which are coupled to each other at an angle of 90 degrees and thereby is obtained a corner of the base12. The constructions of the base's 12 base segments 121, 122, making up a corner of the base, and seals 7 attached thereto, are similar to those depicted earlier in fig. 4C.

In a channel 12a of these two base segments 121, 122 of the base 12 is installed a pair of vertical supports 14; 14' and 14; 14", said vertical supports having mouths 14b, 14b' and 14b; 14b" thereof opening at an angle of 90 degrees relative to each other as presented in fig. 3A. A seamless sealing strip encircles from each base segment 121, 122 to the vertical supports 14; 14' and 14; 14" as illustrated in figs. 3A-3B and 4A-4B. The electrically conductive EMC gasket 7, such as an aluminum strip, extends along the base segment 121, 122 of the base 12 co-directionally with a channel base 12c. When the base segment 121, 122 comes into contact with the vertical supports 14; 14' and 14; 14" (cf. fig. 1A), the result will be a continuous sealing strip extending from the base segment 121, 122 of the base 12 to each vertical support 14.

In addition, the base 12 is provided with two vertical supports 14 and 14, which are installed in a channel 12a of a single base segment 121 of the base 12, and whose mouths 14b, 14b are opening at an angle of 180 degrees relative to each other (cf. fig. 4B). Along one flange of the base's base segment 121 extends a seal, preferably an EMC gasket, which extends co-directionally with its channel base 12c and which, during installation, comes into contact with the EMC gasket of the vertical supports 14, 14 (cf. fig. 1A). Thereby is obtained a continuous sealing strip encircling from the channel 12a of the base segment 121 of the base 12 to each channel 14b of the vertical support 14, 14.

This pair of vertical supports 14, 14, installed in the channel 12a of a single base segment 121, can be used for example as an intermediate support for mounting a door 5 as follows:
A door frame 51 has its bottom piece 51a fitted in a channel 12a present in a base segment 121 of the mounting frame's 1 base 12. The door fame 51 has its first side piece 51b fitted in one of the vertical supports 14; 14' of a pair of vertical supports. The door frame 51 has its second side piece fitted, on the other hand, in the other of the vertical supports 14 installed in the channel 12a of the base's same base segment 121. Hence, the radio-frequency interference suppressing gasket 7 is able to support itself respectively on the bottom piece of the door frame 51 and on each side piece 51b, 51b of the door frame 51. The mounting frame 1 further includes a horizontal door frame support 15 which is coupled to the two vertical supports.

A head piece 51c of the door frame can be installed on said door frame support: the horizontal door frame support 15 is made up of a channel beam 150, having its channel consisting of a channel base whose both longitudinal sides are provided with channel flanges directed away from said channel base, each additionally extending in a direction which is transverse to that of said channel base.

The door frame support 15 has one of its channel flanges fitted with a radio-frequency interference suppressing EMC gasket, which extends co-directionally with the channel beam's 150 channel base.

Therefore, the door frame support 15 has a basic structure similar to those of the vertical support 14 as well as the segment of the base 12, both of which are also made up of channel beams 140, 120.

The door frame support 15 connects to a midsection or top end of the vertical supports 14. Its first end connects to one of the vertical supports 14; 14' of a pair of vertical supports and its second end connects in turn to the other of the vertical supports 14 installed in the channel 12a of the base's same base segment 121.

The door frame has its head piece 51c fitted in a channel of the mounting frame's 1 door frame support 15 in such a way that the radio-frequency interference suppressing gasket 7 supports itself also on the door frame's head piece.

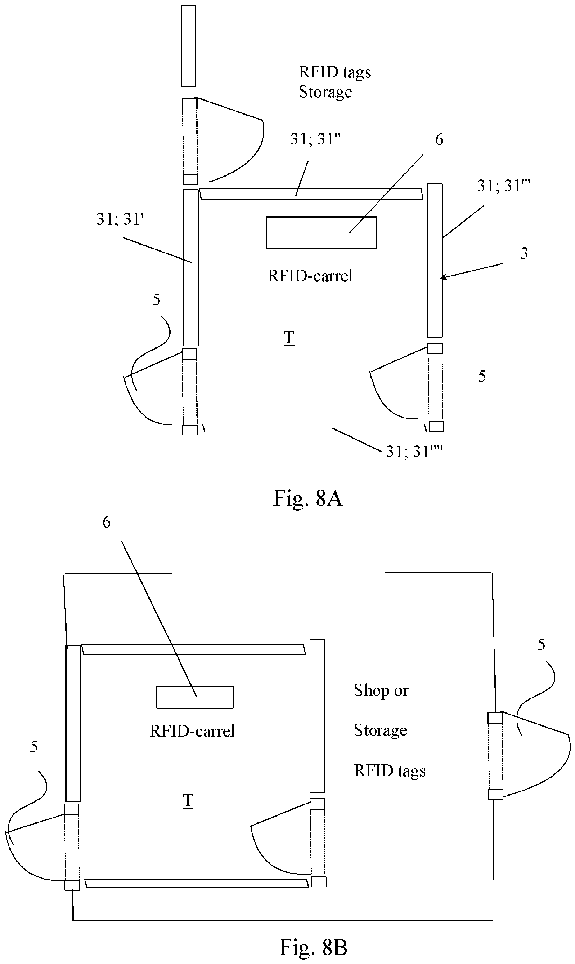

Figs. 8A-8D display various RFID-carrels, which have been constructed with a base and pairs of vertical supports providing an insulation of the invention.

First of all, these figures display a reading carrel 100 for RFID tags, which is located in a transportable container (fig. 8A) and accompanied by a storage space for RFID tags and two doors 5 into an interior of the reading carrel 100. The reading carrel is provided with reading means 6 for RFID tags, comprising an antenna as well as a data processing system by way of which there is provided a capability of reading RFID tags to be retrieved from the storage. The storage is located outside of the reading carrel 100 and, thus, no error signals should be allowed therefrom into the reading carrel. Each door 5 to the reading carrel and all wall elements 31; 31', 31", 31‴, 31"" and ceiling of the wall 3 are arranged in a previously described support frame consisting of channel beams and comprising a base 12, vertical supports 14, top supports 13, and door frame supports 14. The channel beams, included in the mounting frame 1 (=support frame), in a base, in vertical supports, in top supports, and in door frame supports, have the channel flange thereof, which is closer to the reading carrel interior, always provided with an encircling continuous sealing strip which has been made of an EMC gasket. The mounting frame 1 and the wall elements fitted thereto have already been installed on the container floor.

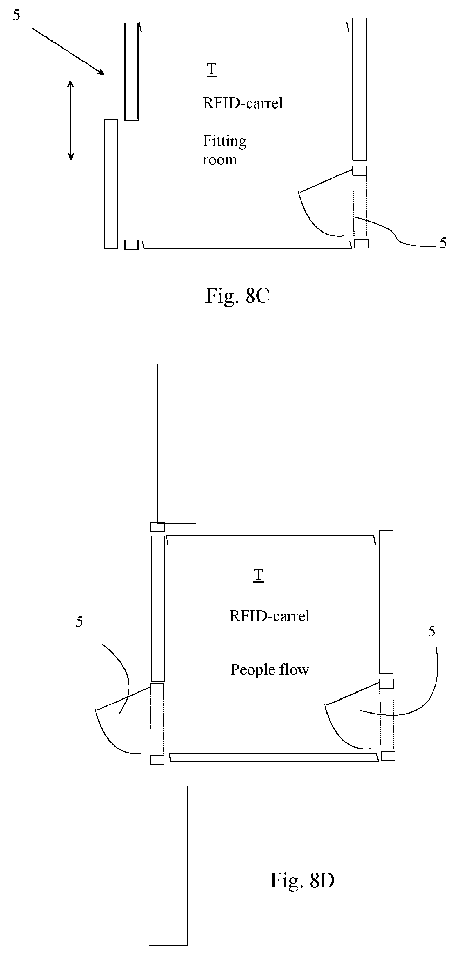

Figs. 8B and 8C display a reading carrel 100 for RFID tags, which is located adjacent to a storage space or a shop carrying objects equipped with RFID tags. In the shop, the door 5 can be a sliding door.

In addition, fig. 8D shows the use of a reading carrel 100 for controlling the passage of persons carrying RFID tags.

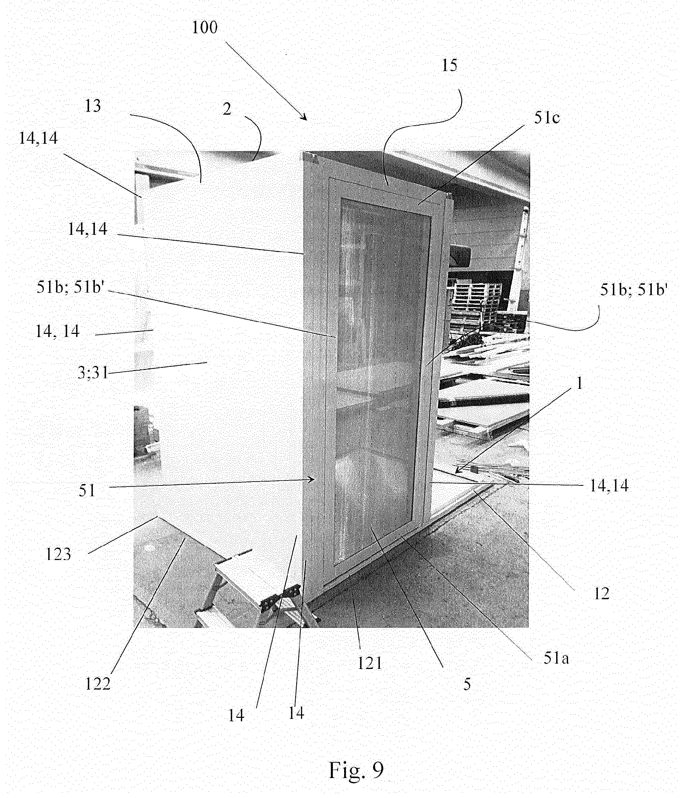

Fig. 9 shows still another reading carrel 100 for RFID tags, which is provided with a glass door. The reading carrel displayed in fig. 9 has been implemented as described in fig. 7B and it comprises a base 12, which includes segments 121 and 122 for the base 12, each of which is made up of a channel beam 120 having a top edge of one channel flange thereof traced by a continuous EMC gasket of electrically conductive material. To the segments 121, 122 of the base 12 is connected a plurality of vertical support pairs 14, 14, each consisting of a channel beam 140. To a top end of these pairs of vertical supports is coupled a door frame support 15 as well as a top support 13, both of which are likewise made up of channel beams. Each vertical support 14 of the pair of vertical supports 14, 14, as well as the door frame support 15, are also provided with a continuous EMC gasket as described previously. The EMC gasket encircles in the form of a continuous sealing strip from a first segment 121 of the base to the vertical supports of a vertical support pair 14, 14 located at a corner of the segments 121, 122, as well as to the vertical supports of a second vertical support pair 14, 14 located on the base's segment 121, and further to the door frame support 15 and to the top support. In addition, the EMC gasket encircles in the form of a continuous sealing strip from a second segment 122 of the base 12 to each vertical support 14 of a vertical support pair 14, 14 located at a corner of segments 122 and 123, as well as further to the top support 13. By fitting the glass door, as depicted in fig. 7B, in the channel of a channel beam 140 of a pair of vertical supports 14, 14, in the channel of a base segment 121, as well as in the channel of a door frame support 15, there is established a structure with the glass door resting by one of its outer edges against the continuous sealing strip. Each wall 31 is installed, as depicted in figs. 7A and 7B, in the channel of a segment for the base 12, in the channel of two vertical supports 14 present at opposite ends of the segment, as well as in the channel of a top support 13 connecting these vertical supports. Thereby, each wall is enabled to bear by one of its outer edges against a continuous sealing strip, which extends from a top edge of the base segment's channel flange to a top edge of both vertical supports' channel flanges, and further to a top edge of the top support's channel flange.

**List of reference numerals**

| | | | |
|---|---|---|---|
| Mounting frame | | | 1 |
| | base | | 12 |
| | | channel | 12a |
| | | mouth | 12b |
| | | channel base | 12c |
| | | channel flanges | 12d |
| | | web | 12g |
| | | lengthwise horizontal plane of the base | 12h |
| | base segment | | 121, 122, 123, 124 |
| | channel beam | | 120 |
| | top support | | 13 |
| | | channel | 13a |
| | | channel base | 13c |
| | | channel flange | 13d |
| | | web | 13g |
| | | channel beam | 130 |
| | vertical support | | 14 |
| | | channel | 14a |
| | | mouth | 14b |
| | | channel base | 14c |
| | | channel flange | 14d |
| | | rear face | 14e |
| | | top or bottom edge (outer edge) | 14f |
| | | web | 14g |
| | | vertical channel | 141 |
| | | channel beam | 140 |
| | door frame support | | 15 |
| | channel beam | | 150 |
| Ceiling | | | 2 |
| Wall | | | 3 |
| | wall element | | 31 |
| | | end face | 31a |
| | | side face adjoining the end face | 31e |
| | | front side | 31b |
| | | rear side | 31c |
| | | top side | 31d |
| | | bottom side, bottom end face | 31f |
| | | channel | 311 |
| | | channel base | 311c |
| | | channel flange | 311d |
| Floor | | | 4 |
| Door | | | 5 |
| | door frame | | 51 |
| | | bottom piece of the door frame | 51a |
| | | side piece of the door frame | 51b |
| | | head piece of the door frame | 51c |
| Reading means | | | 6 |
| Radio-frequency radiation suppressing gasket | | | 7 |
| EMC gasket | | | 7a |
| Adapter | | | 8 |
| | End face adapter | | 80 |
| | end face adapter bearing surface | | 80a |
| | end face adapter protruding distance | | 80h |
| | Inner adapter | | 90 |
| Auxiliary mounting frame | | | 9 |
| Reading carrel | | | 100 |
| | interior | | T |

## Claims

1. A reading carrel (100) which encloses RFID tags, said reading carrel having a ceiling (2), a floor (4), at least one door (5), as well as walls (3) encircling the reading carrel (100) and including a plurality of interconnected wall elements (31), as well as a mounting frame (1) for the walls (3) and the at least one door (5), as well as means for reading RFID tags in the reading carrel (100), wherein said reading carrel has its
- mounting frame (1) comprising a horizontal base (12) extending around an interior (T) of the reading carrel (100) and consisting of a plurality of interconnected base segments (121, 122, 123, 124), said base being connected with a plurality of vertical supports (14), wherein
- reading means (6) for RFID tags comprise an antenna as well as a data processing system, both of which provide a capability of reading RFID tags,
- each base segment (121, 122, 123, 124) of the mounting frame (1) is made up of a channel beam (120) and each vertical support (14) is also made of a channel beam (140), said channel beams (120, 140) having channels (12a, 14a) thereof consisting of a channel base (12c, 14c) which is provided on both sides with channel flanges (12d, 14d) directed away from said channel base (12c, 14c), each channel flange (12d, 14d) extending in a direction transverse to that of said channel base,
- each wall element (31) of each of the walls (3) has its lower end fitted in the channel (12c) of the mounting frame's (1) base (12) and, moreover, each wall (3) has both end faces (31a, 31a) thereof fitted in the channel (14a) of the mounting frame's (1) vertical support (14),
- between at least one base segment (121, 122, 123, 124) as well as a lower end of the wall element (31) mounted thereon is fitted a radio-frequency interference suppressing seal (7), which is an EMC gasket, which extends co-directionally with the channel base (12c) of a channel beam (120) comprising said base segment (121, 122, 123, 124), whereby between at least one vertical side face (31e) adjoining at least one end face (31a) of a wall element (31) mounted on said base segment (121, 122, 123, 124) and the channel flange (14d) of the channel (14a) of the channel beam (140) comprising the vertical support (14) mounted on the very same base segment (121, 122, 123, 124) is likewise fitted a radio-frequency interference suppressing seal (7), which is an EMC gasket, which extends co-directionally with the channel (14c) of the channel beam (140) comprising said vertical support (14), such that the aforesaid radio-frequency interference suppressing seal (7) which is an EMC-gasget extends in a substantially continuous manner from the base segment (121, 122, 123, 124) to the channel flange (14d) of at least one vertical support (14).

2. A reading carrel (100) which encloses RFID tags according to claim 1, in which the at least one door (5) includes a door element as well as a door frame (51) which encircles the door element, **characterized in that** the door frame (51) has its bottom piece (51a) fitted in the channel (12a) of a base segment (121, 122, 123, 124) of the mounting frame's (1) base (12), and that the door frame (51) has each side piece (51b) thereof fitted in the channel (14a) of a vertical support (14) of the mounting frame (1), whereby at least one elongated EMC-gasket (7) is installed respectively between the bottom piece (51a) of the door frame (51) and the channel (12a) of the base segment (121, 122, 123, 124), as well as at least one elongated radio-frequency interference suppressing seal (7) is also installed between each side piece (51b) of the door frame (51) and the channel (14a) of the vertical support (14).

3. A reading carrel (100) which encloses RFID tags according to claim 1, **characterized in that** the door (5) is a sliding door which is fitted in the channel of a base segment (121, 122, 123, 124) of the mounting frame's (1) base (12).

4. A reading carrel (100) which encloses RFID tags according to any of the preceding claims, **characterized in that** the mounting frame (1) further comprises a top support (13) co-directional with the mounting frame's base (12) and associated with a top end of the vertical supports (14), and said top support (13) consists of a channel beam (130), the top support (13) having its channel (13a) made up of a channel base (13c) which is provided on both sides with channel flanges (13b) directed away from the channel base (13c), each in a direction transverse to that of said channel base (13c), whereby
- each wall element (31) of each of the walls (3) has its top end fitted in the channel (13c) of the mounting frame's (1) top support (13), and
- between at least one channel flange (13d) of the top support (13) and a top end of the wall element (31) is installed a radio-frequency interference suppressing seal (7), which is an EMC gasket, which extends co-directionally with the channel beam's channel base (13c).

5. A reading carrel (100) which encloses RFID tags according to any of the preceding claims, **characterized in that**
- the mounting frame further comprises a horizontal door frame support (15), which is associated with a midsection or top end of the vertical supports (14), and which door frame support (15) consists of a channel beam (150) whose channel is made up of a channel base provided on both sides thereof with channel flanges directed away from the channel base, each extending in a direction which is transverse to that of said channel base , whereby
- the door frame support (15) has at least one of its channel flanges fitted with a radio-frequency interference suppressing seal (7),which is an EMC gasket, which extends co-directionally with the channel base, and
- the door frame's head piece is fitted in a channel of the mounting frame's (1) door frame support (15) in such a way that the aforesaid radio-frequency interference suppressing seal (7) which is EMC-gasget is also supported on the door frame's head piece.

6. A reading carrel (100) which encloses RFID tags according to claim 4 **characterized in that** a first radio-frequency interference suppressing seal (7) which is an EMC-gasget extends in a continuous manner from a channel flange (12d) of the channel (12a) in the base (12) of the mounting frame (1) to a channel flange (14d) of the channel (14a) in two vertical supports (14) associated therewith, and to a channel flange (13d) of the channel (13a) in the top support (13).

7. A reading carrel (100) which encloses RFID tags according to claim 5, **characterized in that** a second radio-frequency interference suppressing seal (7) which is an EMC-gasget extends in a continuous manner from a channel flange (12d) of the channel (12a) in the base (12) of the mounting frame (1) to a channel flange (14d) of the channel (14a) in a vertical support (14) and further to a channel flange of the channel in the door frame support (15).

8. A reading carrel (100) which encloses RFID tags according to any of the preceding claims, **characterized in that** the vertical support (14) is made up of two channel beams (140) in contact with each other.

9. A reading carrel (100) which encloses RFID tags according to claim 8, **characterized in that** the channel beams (140) have mouths of the vertical channels (14a, 14a) thereof opening in opposite directions.

10. A reading carrel (100) which encloses RFID tags according to claim 8, **characterized in that** the channel beams (140) have mouths of the vertical channels (14a) thereof directed at an angle of 90 degrees relative to each other.

11. A reading carrel (100) which encloses RFID tags according to any of claims 8-10, **characterized in that** the channel beams (140) are attached to each other or integrated for a single piece.

12. A reading carrel (100) which encloses RFID tags according to any of the preceding claims, **characterized in that** the channel (14a) of the each of the plurality vertical supports (14) opens in a lengthwise direction of the base segment (121, 122, 122, 123) of the mounting frame's (1) base (12).

13. A reading carrel (100) which encloses RFID tags according to claim 4, **characterized in that** the each of the plurality vertical supports (14) comprises a channel beam (140), provided at its bottom and/or top end with an adapter (8) for installing said vertical support (14) in the channel (12a) of a base segment of the mounting frame's base (12) and/or in the channel (13a) of the top support (13).

14. A reading carrel (100) which encloses RFID tags according to claim 13, **characterized in that** the seal (7) lengthwise of the each of the plurality vertical supports (14) extends to a channel (12a) of the base (12) and/or to the channel (13a) of the top support (13).

15. A reading carrel (100) which encloses RFID tags, said reading carrel having a ceiling (2), a floor (4), at least one door (5), as well as walls (3) encircling the reading carrel (100) and including a plurality of interconnected wall elements (31), as well as a mounting frame (1) for the walls (3) and the at least one door (5), as well as means for reading RFID tags in the reading carrel (100), wherein the reading carrel has
- its mounting frame (1) comprising a horizontal base (12) extending around an interior (T) of the reading carrel (100) and consisting of a plurality of interconnected base segments, said base being provided with a plurality of vertical supports (14), each base segment as well as vertical support (14) of the mounting frame (1) being respectively made of a beam provided with a web (12g, 14g) which is directed upwards from the beam's horizontal plane or sideways from the beam's vertical plane and which extends in a longitudinal direction of the beam,
- the bottom end as well as both end faces (31a) of each of the interconnected wall elements (31) provided with an elongated channel (311) which is made up of a channel base (31c) provided on both sides thereof with channel flanges (31d) directed away from the channel base, each extending in a direction transverse to that of said channel base, whereby
each of the walls (3) has the channel (311) of a bottom end of its wall element (31) and the channel (311) of each end face (31a) of its wall element (31) fitted on the web (12g) of the mounting frame,
between the bottom end channel (311) of each of the interconnected wall elements (31) and the web (12g) of a base segment (121, 122, 123, 124) of the mounting frame (1) is fitted at least one radio-frequency interference suppressing seal (7), which is an EMC gasket (71), which extends co-directionally with a channel base (31c) of said channel (311), and
between the channel (311) of each end face (31) and the web (14g) of a respective vertical support (14) is also fitted at least one radio-frequency interference suppressing seal (7), which is an EMC gasket (7a), which extends in a lengthwise direction of the vertical support (14),
reading means (6) for RFID tags comprise an antenna as well as a data processing system, both of which provide a capability of reading RFID tags.

16. A reading carrel (100) which encloses RFID tags according to claim 15, in which at least one door (5) includes a door element as well as a door frame (51) encircling the door element, **characterized in that** the door frame (51) has its bottom piece (51a) and each side piece (51b, 51b) of the door frame (51) provided with a channel, which is made up of a channel base having both sides thereof provided with channel flanges directed away from the channel base, each extending in a direction transverse to that of said channel base, and
at least one of the channel flanges of a channel in the bottom piece (51a) of the door frame (51) and at least one of the channel flanges of each side piece (51b, 51b) thereof is fitted with a radio-frequency interference suppressing seal (7), which is an EMC gasket, which extends co-directionally with said channel base, whereby each side piece (51b, 51b) of the door frame (51) is fitted on a web (41g) of the mounting frame's vertical support (14) in such a way that the aforesaid at least one EMC-gasket (7) is also in contact with the web (14g) of the mounting frame's vertical supports (14),
the door frame (51) has its bottom piece (51a) fitted on a base segment (121, 122, 123, 124) in such a way that the aforesaid at least one EMC-gasket (7) is also in contact with the web (12g) of the base segment of the mounting frame's base (12).

17. A reading carrel (100) which encloses RFID tags according to claim 15 or 16, **characterized in that** the door (5) is a sliding door, which fitted on a web (12g) rising from a base segment (121, 122, 123, 124) of the mounting frame's (1) base (12).

18. A reading carrel (100) which encloses RFID tags according to any of the preceding claims 15-17, **characterized in that**
- the mounting frame (1) further comprises a top support (13), which is co-directional with the base (12) of the mounting frame (1) and associated with a top end of the vertical supports (14), and said top support (13) consists of a beam which includes a web (13g) directed downward from the beam's horizontal plane and extending co-directionally with a longitudinal direction of the top support (13), whereby the wall (3) has a top end of its wall elements (31) and/or the door frame (51) has a top end of its head piece provided with an elongated channel (311), which is made up of a channel base provided on both sides thereof with channel flanges directed away from the channel base, each extending in a direction transverse to that of said channel base,
- each wall element (31) of the wall (3) has its top end channel (311) and/or the door frame (51) has the top end channel (311) of its head piece fitted on said web (13g) of the mounting frame's (1) top support (13),
- between at least one channel flange of the top end channel of each wall element (31) of the wall (3) and the web (13g) of the top support (13) is fitted an elongated radio-frequency interference suppressing seal (7), which is an EMC gasket (7a), which extends co-directionally with the top end channel (311) of said wall element (31).

19. A reading carrel (100) which encloses RFID tags according to preceding claim 18, **characterized in that** the EMC-gasket (7) extends in a continuous manner from the web (12g) of a base segment of the mounting frame's (1) base (12) to the web (14g) of a vertical support (14) associated with two base segments, an to the web (13g) of the top support (13).

20. A reading carrel (100) which encloses RFID tags according to claim 19, **characterized in that** the EMC-gasket (7) extends in a continuous manner from a bottom end face of the wall (31) to each side face of the wall (31).

21. A reading carrel (100) which encloses RFID tags according to claim 18 or 19, **characterized in that** the EMC-gasket (7) extends in a continuous manner from the web (12g) of a base segment of the mounting frame's (1) base (12) to the web (14g) of a vertical support (14), and further to the web of a door frame support (15).

22. A reading carrel (100) which encloses RFID tags according to any of the preceding claims 15-21, **characterized in that** two vertical supports (14) are coupled to each other in such a way that the webs (14g) thereof are directed in opposite directions.

23. A reading carrel (100) which encloses RFID tags according to any of the preceding claims 15-21, **characterized in that** two vertical supports (14) are coupled to each other in such a way that the webs (14g) thereof are directed at an angle of 90 degrees relative to each other.

24. A reading carrel (100) which encloses RFID tags according to any of the preceding claims, **characterized in that** under the mounting frame's base (12) is installed an auxiliary mounting frame (9) for adjusting direction of the mounting frame's base (12) with respect to the ground or the foundation of a building.

25. A reading carrel (100) which encloses RFID tags according to any of the preceding claims 1-24, wherein the radio-frequency interference suppressing seal is a metal gasket.

26. A reading carrel (100) which encloses RFID tags according to any of the preceding claims 1-25, wherein the radio-frequency interference suppressing seal is EMC-gasget made of a metal such as aluminum, and designed with mutually form-locking shapes for base segments (121, 122, 123, 124) of the mounting frame's base (12) and for vertical supports (14) of the mounting frame, as well as for wall elements of the wall to be coupled thereto.

27. A reading carrel (100) which encloses RFID tags according to any of the preceding claims 1-26, which is located in a transportable container.

28. A reading carrel (100) which encloses RFID tags according to any of the preceding claims 1-27, which is located in the proximity of a storage space or shop, said storage or shop carrying objects provided with RFID tags.

29. Use of a reading carrel (100) which encloses RFID tags according to any of the preceding claims 1-28 for controlling entries and exits of persons in possession of RFID tags.

## Patentansprüche

1. Lesekabine (100), die RFID-Etiketten umschließt, wobei die Lesekabine eine Decke (2), einen Boden (4), mindestens eine Tür (5) sowie Wände (3), die die Lesekabine (100) umgeben, und mehrere miteinander verbundene Wandelemente (31) umfassen, sowie einen Montagerahmen (1) für die Wände (3) und die mindestens eine Tür (5), sowie Mittel zum Lesen von RFID-Etiketten in der Lesekabine (100) aufweist, wobei die Lesekabine Folgendes aufweist:
- ihren Montagerahmen (1), umfassend eine horizontale Basis (12), die sich um einen Innenraum (T) der Lesekabine (100) erstreckt und aus mehreren miteinander verbundenen Basissegmenten (121, 122, 123, 124) besteht, wobei die Basis mit mehreren vertikalen Stützen (14) verbunden ist, wobei
- Lesemittel (6) für RFID-Etiketten eine Antenne sowie ein Datenverarbeitungssystem umfassen, die beide eine Fähigkeit zum Lesen von RFID-Etiketten bereitstellen,
- jede Basissegment (121, 122, 123, 124) des Montagerahmens (1) aus einem Kanalträger (120) besteht und jede vertikale Stütze (14) ebenfalls aus einem Kanalträger (140) besteht, wobei die Kanalträger (120, 140) Kanäle (12a, 14a) aufweisen, die aus einer Kanalbasis (12c, 14c) bestehen, die auf beiden Seiten mit Kanalflanschen (12d, 14d) versehen ist, die von der Kanalbasis (12c, 14c) weggerichtet sind, wobei sich jeder Kanalflansch (12d, 14d) in einer Richtung quer zu der der Kanalbasis erstreckt,
- jedes Wandelement (31) jeder der Wände (3) mit seinem unteren Ende in den Kanal (12c) der Basis (12) des Montagerahmens (1) eingepasst ist und darüber hinaus, jede Wand (3) mit ihren beiden Endflächen (31a, 31a) in den Kanal (14a) der vertikalen Stütze (14) des Montagerahmens (1) eingepasst ist,
- zwischen mindestens einem Basissegment (121, 122, 123, 124) sowie einem darauf montierten unteren Ende des Wandelements (31) eine Hochfrequenz-Störunterdrückungsdichtung (7) angebracht ist, die eine EMV-Dichtung ist, der sich gleichgerichtet mit der Kanalbasis (12c) eines Kanalträgers (120) erstreckt, der das Basissegment (121, 122, 123, 124) umfasst, wobei zwischen mindestens einer vertikalen Seitenfläche (31e), die an mindestens eine Stirnseite (31a) eines auf dem Basissegment (121, 122, 123, 124) montierten Wandelements (31) angrenzt, und dem Kanalflansch (14d) des Kanals (14a) des Kanalträgers (140), der die vertikale Stütze (14), die auf demselben Basissegment (121, 122, 123, 124) montiert ist, umfasst, ebenfalls eine Hochfrequenzentstörungsdichtung (7) angebracht ist, die eine EMV-Dichtung ist, die sich in gleicher Richtung mit dem Kanal (14c) des Kanalträgers (140) erstreckt, der die vertikale Stütze (14) umfasst, so dass sich die vorgenannte Hochfrequenz-Störunterdrückungsdichtung (7), die ein EMV-Dichtungselement ist, im Wesentlichen durchgehend vom Basissegment (121, 122, 123, 124) bis zum Kanalflansch (14d) mindestens einer vertikalen Stütze (14) erstreckt.

2. Lesekabine (100), die RFID-Etiketten umschließt, nach Anspruch 1, bei der die mindestens eine Tür (5) ein Türelement sowie einen das Türelement umlaufenden Türrahmen (51) umfasst, **dadurch gekennzeichnet, dass** das Bodenteil (51a) des Türrahmens (51) in den Kanal (12a) eines Basissegments (121, 122, 123, 124) der Basis (12) des Montagerahmens (1) eingepasst ist, und dass jedes Seitenteil (51b) des Türrahmens (51) in den Kanal (14a) einer vertikalen Stütze (14) des Montagerahmens (1) eingepasst ist, wobei zwischen dem Bodenteil (51a) des Türrahmens (51) und dem Kanal (12a) des Basissegments (121, 122, 123, 124) jeweils mindestens eine längliche EMV-Dichtung (7) eingebaut ist, sowie zwischen jedem Seitenteil (51b) des Türrahmens (51) und dem Kanal (14a) der vertikalen Stütze (14) mindestens eine längliche Hochfrequenz-Störunterdrückungsdichtung (7) eingebaut ist.

3. Lesekabine (100), die RFID-Etiketten umschließt, nach Anspruch 1, **dadurch gekennzeichnet, dass** die Tür (5) eine Schiebetür ist, die in den Kanal eines Basissegments (121, 122, 123, 124) der Basis (12) des Montagerahmens (1) eingepasst ist.

4. Lesekabine (100), die RFID-Etiketten umschließt, nach einem der vorhergehenden Ansprüche, **dadurch gekennzeichnet, dass** der Montagerahmen (1) ferner eine obere Stütze (13) umfasst, die gleichlaufend mit der Basis (12) des Montagerahmens und einem oberen Ende der vertikalen Stützen (14) zugeordnet ist, und die obere Stütze (13) aus einem Kanalträger (130) besteht, wobei die obere Stütze (13) einen Kanal (13a) aufweist, der aus einer Kanalbasis (13c) besteht, die beidseitig mit von der Kanalbasis (13c) weggerichteten Kanalflanschen (13b) versehen ist, die jeweils in einer Richtung quer zu der der Kanalbasis (13c) liegen, wobei
- jedes Wandelement (31) jeder der Wände (3) mit seinem oberen Ende in den Kanal (13c) der oberen Stütze (13) des Montagerahmens (1) eingepasst ist, und
- zwischen mindestens einem Kanalflansch (13d) der oberen Stütze (13) und einem oberen Ende des Wandelements (31) eine Hochfrequenz-Störunterdrückungsdichtung (7) eingebaut ist, die eine EMV-Dichtung ist, die sich in gleicher Richtung mit der Kanalbasis (13c) des Kanalträgers erstreckt.

5. Lesekabine (100), die RFID-Etiketten umschließt, nach einem der vorhergehenden Ansprüche, **dadurch gekennzeichnet, dass**
- der Montagerahmen ferner eine horizontale Türrahmenstütze (15) umfasst, die einem mittleren Abschnitt oder oberen Ende der vertikalen Stützen (14) zugeordnet ist, und wobei die Türrahmenstütze (15) aus einem Kanalträger (150) besteht, dessen Kanal aus einer Kanalbasis besteht, die auf beiden Seiten mit von der Kanalbasis weg gerichteten Kanalflanschen versehen ist, die sich jeweils in einer Richtung erstrecken, die quer zu der der Kanalbasis ist, wobei
- die Türrahmenstütze (15) mindestens einen seiner Kanalflansche aufweist, der mit einer Hochfrequenzstörungs-Unterdrückungsdichtung (7) ausgestattet ist, die eine EMV-Dichtung ist, die sich in gleicher Richtung mit der Kanalbasis erstreckt, und
- das Kopfstück des Türrahmens in einen Kanal der Türrahmenstütze (15) des Montagerahmens (1) derart eingesetzt wird, dass sich die oben erwähnte Hochfrequenzstörungs-Unterdrückungsdichtung (7), die EMV-Dichtung ist, auch auf dem Kopfstück des Türrahmens abstützt.

6. Lesekabine (100), die RFID-Etiketten umschließt, nach Anspruch 4, **dadurch gekennzeichnet, dass** sich eine erste Hochfrequenzstörungs-Unterdrückungsdichtung (7), die ein EMV-Dichtungselement ist, durchgehend von einem Kanalflansch (12d) des Kanals (12a) in der Basis (12) des Montagerahmens (1) zu einem Kanalflansch (14d) der Rinne (14a) in zwei diesen zugeordneten vertikalen Stützen (14) und zu einem Kanalflansch (13d) des Kanals (13a) in der oberen Stütze (13) erstreckt.

7. Lesekabine (100), die RFID-Etiketten umschließt, nach Anspruch 5, **dadurch gekennzeichnet, dass** sich eine zweite Hochfrequenzstörungs-Unterdrückungsdichtung (7), die eine EMV-Dichtung ist, durchgehend von einem Kanalflansch (12d) des Kanals (12a) in der Basis (12) des Montagerahmens (1) zu einem Kanalflansch (14d) des Kanals (14a) in einer vertikalen Stütze (14) und weiter zu einem Kanalflansch des Kanals in der Türrahmenstütze (15) erstreckt.

8. Lesekabine (100), die RFID-Etiketten umschließt, nach einem der vorhergehenden Ansprüche, **dadurch gekennzeichnet, dass** die vertikale Stütze (14) aus zwei miteinander in Kontakt stehenden Kanalträgern (140) besteht.

9. Lesekabine (100), die RFID-Etiketten umschließt, nach Anspruch 8, **dadurch gekennzeichnet, dass** die Kanalträger (140) Mündungen ihrer vertikalen Kanäle (14a, 14a) aufweisen, die sich in entgegengesetzte Richtungen öffnen.

10. Lesekabine (100), die RFID-Etiketten umschließt, nach Anspruch 8, **dadurch gekennzeichnet, dass** die Mündungen der vertikalen Kanäle (14a) der Kanalträger (140) in einem Winkel von 90 Grad zueinander gerichtet sind.

11. Lesekabine (100), die RFID-Etiketten umschließt, nach einem der Ansprüche 8 bis 10, **dadurch gekennzeichnet, dass** die Kanalträger (140) aneinander befestigt oder einstückig integriert sind.

12. Lesekabine (100), die RFID-Etiketten umschließt, nach einem der vorangehenden Ansprüche, **dadurch gekennzeichnet, dass** der Kanal (14a) jeder der mehreren vertikalen Stützen (14) in einer Längsrichtung des Basissegments (121, 122, 122, 123) der Basis (12) des Montagerahmens (1) geöffnet ist.

13. Lesekabine (100), die RFID-Etiketten umschließt, nach Anspruch 4, **dadurch gekennzeichnet, dass** jede der mehreren vertikalen Stützen (14) einen Kanalträger (140) umfasst, die an ihrem unteren und/oder oberen Ende mit einem Adapter (8) zum Installieren der vertikalen Stütze (14) in dem Kanal (12a) eines Basissegments der Basis (12) des Montagerahmens und/oder im Kanal (13a) des oberen Trägers (13) versehen ist.

14. Lesekabine (100), die RFID-Etiketten umschließt, nach Anspruch 13, **dadurch gekennzeichnet, dass** sich die Dichtung (7) längs jeder der mehreren vertikalen Stützen (14) zu einem Kanal (12a) der Basis (12) und/oder zum Kanal (13a) des oberen Trägers (13) erstreckt.

15. Lesekabine (100), die RFID-Etiketten umschließt, wobei die Lesekabine eine Decke (2), einen Boden (4), mindestens eine Tür (5), sowie Wände (3), die die Lesekabine (100) umgeben und mehrere miteinander verbundene Wandelemente (31) umfassen, sowie einen Montagerahmen (1) für die Wände (3) und die mindestens eine Tür (5), sowie Mittel zum Lesen von RFID-Etiketten in der Lesekabine (100) aufweist, wobei die Lesekabine Folgendes aufweist
- seinen Montagerahmen (1), umfassend eine horizontale Basis (12), die sich um einen Innenraum (T) der Lesekabine (100) erstreckt und aus mehreren miteinander verbundenen Basissegmenten besteht, wobei die Basis mit mehreren vertikalen Stützen (14) versehen ist, wobei jedes Basissegment sowie der vertikalen Stützen (14) des Montagerahmens (1) jeweils aus einem Träger bestehen, der mit einem Steg (12g, 14g) versehen ist, der von der horizontalen Ebene des Trägers nach oben oder von der vertikalen Ebene des Trägers seitlich gerichtet ist und der sich in Längsrichtung des Trägers erstreckt,
- das untere Ende sowie beide Stirnseiten (31a) jedes der miteinander verbundenen Wandelemente (31) mit einem länglichen Kanal (311) versehen sind, der aus einem Kanalboden (31c) besteht, der auf beiden Seiten mit vom Kanalboden abgewandten Kanalflanschen (31d) versehen ist, die sich jeweils in einer Richtung quer zu der der Kanalbasis erstrecken, wobei
jede der Wände (3) den Kanal (311) eines unteren Endes ihres Wandelements (31) und den Kanal (311) jeder Stirnseite (31a) seines auf dem Steg (12g) des Montagerahmens angebrachten Wandelements (31) aufweist, zwischen dem unteren Endkanal (311) jedes der miteinander verbundenen Wandelemente (31) und dem Steg (12g) eines Basissegments (121, 122, 123, 124) des Montagerahmens (1) mindestens eine Hochfrequenzstörungs-Unterdrückungsdichtung (7) eingebaut ist, die eine EMV-Dichtung (71) ist, die sich in gleicher Richtung mit einer Kanalbasis (31c) des Kanals (311) erstreckt, und
zwischen dem Kanal (311) jeder Stirnseite (31) und dem Steg (14g) einer jeweiligen vertikalen Stütze (14) außerdem mindestens eine Hochfrequenzstörungs-Unterdrückungsdichtung (7) angebracht ist, die eine EMV-Dichtung (7a) ist, die sich in Längsrichtung der vertikalen Stütze (14) erstreckt,
Lesemittel (6) für RFID-Etiketten eine Antenne sowie ein Datenverarbeitungssystem umfassen, die beide eine Fähigkeit zum Lesen von RFID-Etiketten bereitstellen.

16. Lesekabine (100), die RFID-Etiketten umschließt, nach Anspruch 15, bei der mindestens eine Tür (5) ein Türelement sowie einen das Türelement umlaufenden Türrahmen (51) aufweist, **dadurch gekennzeichnet, dass** der Türrahmen (51) sein unteres Teil (51a) und jedes Seitenteil (51b, 51b) des Türrahmens (51) aufweist, die mit einem Kanal versehen sind, der aus einem Kanalboden besteht, dessen beide Seiten mit von dem Kanalboden weg gerichteten Kanalflanschen versehen sind, die sich jeweils in einer Richtung quer zu der der Kanalbasis erstrecken, und
mindestens einer der Kanalflansche eines Kanals im Bodenteil (51a) des Türrahmens (51) und mindestens einer der Kanalflansche jedes Seitenteils (51b, 51b) davon mit einer Hochfrequenzstörungs-Unterdrückungsdichtung (7) ausgestattet ist, die eine EMV-Dichtung ist, die sich in gleicher Richtung mit der Kanalbasis erstreckt, wobei
jedes Seitenteil (51b, 51b) des Türrahmens (51) an einem Steg (41g) des vertikalen Trägers (14) des Montagerahmens derart angebracht ist, dass die vorgenannte mindestens eine EMV-Dichtung (7) auch in Kontakt mit dem Steg (14g) der vertikalen Stützen (14) des Montagerahmens steht,
der Türrahmen (51) mit seinem Bodenteil (51a) auf einem Basissegment (121, 122, 123, 124) derart montiert ist, dass die vorgenannte mindestens eine EMV-Dichtung (7) auch in Kontakt mit dem Steg (12g) des Basissegments der Basis (12) des Montagerahmens steht.

17. Lesekabine (100), die RFID-Etiketten umschließt, nach Anspruch 15 oder 16, **dadurch gekennzeichnet, dass** die Tür (5) eine Schiebetür ist, die auf einem Steg (12g) sitzt, der sich von einem Basissegment (121, 122, 123, 124) der Basis (12) des Montagerahmens (1) erhebt.

18. Lesekabine (100), die RFID-Etiketten umschließt, nach einem der vorhergehenden Ansprüche 15-17, **dadurch gekennzeichnet, dass**
- der Montagerahmen (1) ferner eine obere Stütze (13) umfasst, die gleichgerichtet mit der Basis (12) des Montagerahmens (1) ist und einem oberen Ende der vertikalen Stützen (14) zugeordnet ist, und die obere Stütze (13) aus einem Träger besteht, der einen Steg (13g) enthält, der von der horizontalen Ebene des Trägers nach unten gerichtet ist und sich gleichgerichtet mit einer Längsrichtung der oberen Stütze (13) erstreckt, wobei die Wand (3) ein oberes Ende ihrer Wandelemente (31) und/oder der Türrahmen (51) ein oberes Ende ihres Kopfstücks hat, das mit einem länglichen Kanal (311) versehen ist, die aus einem Kanalboden besteht, der auf beiden Seiten mit vom Kanalboden abgewandten Kanalflanschen versehen ist, die sich jeweils in einer Richtung quer zu der der Kanalbasis erstrecken,
- jedes Wandelement (31) der Wand (3) seinen oberen Endkanal (311)aufweist und/oder der Türrahmen (51) den oberen Endkanal (311) seines Kopfstücks aufweist, das an dem Steg (13g) der oberen Stütze (13) des Montagerahmens (1) angebracht ist,
- zwischen mindestens einem Kanalflansch des oberen Endkanals jedes Wandelements (31) der Wand (3) und dem Steg (13g) der oberen Stütze (13) eine längliche Hochfrequenzstörungs-Unterdrückungsdichtung (7) angebracht ist, die eine EMV-Dichtung (7a) ist, die sich in gleicher Richtung mit dem oberen Endkanal (311) des Wandelements (31) erstreckt.

19. Lesekabine (100), die RFID-Etiketten umschließt, nach vorhergehendem Anspruch 18, **dadurch gekennzeichnet, dass** die EMV-Dichtung (7) durchgehend vom Steg (12g) eines Basissegments der Basis (12) des Montagerahmens (1) zum Steg (14g) einer zwei Basissegmenten zugeordneten vertikalen Stütze (14) und zum Steg (13g) der oberen Stütze (13) verläuft.

20. Lesekabine (100), die RFID-Etiketten umschließt, nach Anspruch 19, **dadurch gekennzeichnet, dass** sich die EMV-Dichtung (7) durchgehend von einer unteren Stirnseite der Wand (31) zu jeder Seitenfläche der Wand (31) erstreckt.

21. Lesekabine (100), die RFID-Etiketten umschließt, nach Anspruch 18 oder 19, **dadurch gekennzeichnet, dass** die EMV-Dichtung (7) durchgehend vom Steg (12g) eines Basissegments der Basis (12) des Montagerahmens (1) zum Steg (14g) einer vertikalen Stütze (14) und weiter zum Steg einer Türrahmenstütze (15) verläuft.

22. Lesekabine (100), die RFID-Etiketten umschließt, nach einem der vorhergehenden Ansprüche 15 bis 21, **dadurch gekennzeichnet, dass** zwei vertikale Stützen (14) derart miteinander gekoppelt sind, dass ihre Stege (14g) in entgegengesetzte Richtungen gerichtet sind.

23. Lesekabine (100), die RFID-Etiketten umschließt, nach einem der vorhergehenden Ansprüche 15 bis 21, **dadurch gekennzeichnet, dass** zwei vertikale Stützen (14) derart miteinander gekoppelt sind, dass ihre Stege (14g) in einem Winkel von 90 Grad zueinander gerichtet sind.

24. Lesekabine (100), die RFID-Etiketten umschließt, nach einem der vorhergehenden Ansprüche, **dadurch gekennzeichnet, dass** unter der Basis (12) des Montagerahmens ein Hilfsmontagerahmen (9) zum Justieren der Richtung der Basis (12) des Montagerahmens in Bezug auf den Boden oder das Fundament eines Gebäudes installiert ist.

25. Lesekabine (100), die RFID-Etiketten umschließt, nach einem der vorangehenden Ansprüche 1 bis 24, wobei die Hochfrequenzstörungs-Unterdrückungsdichtung eine Metalldichtung ist.

26. Lesekabine (100), die RFID-Etiketten umschließt, nach einem der vorangehenden Ansprüche 1 bis 25, wobei die Hochfrequenzstörungs-Unterdrückungsdichtung eine EMV-Dichtung aus einem Metall wie Aluminium ist, und mit zueinander formschlüssigen Ausformungen für Basissegmente (121, 122, 123, 124) des Montagerahmens (12) und für vertikale Stützen (14) des Montagerahmens sowie für Wandelemente der Wand, die daran gekoppelt werden sollen, ausgelegt ist.

27. Lesekabine (100), die RFID-Etiketten umschließt, nach einem der vorhergehenden Ansprüche 1 bis 26, die sich in einem transportierbaren Behälter befindet.

28. Lesekabine (100), die RFID-Etiketten umschließt, nach einem der vorhergehenden Ansprüche 1 bis 27, die sich in der Nähe eines Lagerraums oder Ladens befindet, wobei das Lager oder der Laden Gegenstände aufnimmt, die mit RFID-Etiketten versehen sind.

29. Verwendung einer Lesekabine (100), die RFID-Etiketten umschließt, nach einem der vorhergehenden Ansprüche 1 bis 28, zum Kontrollieren von Ein- und Ausgängen von Personen, die im Besitz von RFID-Etiketten sind.

## Revendications

1. Cabine de lecture (100) qui renferme des étiquettes RFID, ladite cabine de lecture ayant un plafond (2), un plancher (4), au moins une porte (5), ainsi que des cloisons (3) entourant la cabine de lecture (100) et comportant une pluralité d'éléments de cloison reliés entre eux (31), ainsi qu'un cadre de montage (1) pour les cloisons (3) et l'au moins une porte (5), ainsi que des moyens pour lire les étiquettes RFID dans la cabine de lecture (100), dans laquelle ladite cabine de lecture a son
- cadre de montage (1) comprenant une base horizontale (12) s'étendant autour d'un intérieur (T) de la cabine de lecture (100) et constitué d'une pluralité de segments de base reliés entre eux (121, 122, 123, 124), ladite base étant reliée à une pluralité de supports verticaux (14), dans laquelle
- des moyens de lecture (6) pour les étiquettes RFID comprennent une antenne ainsi qu'un système de traitement des données, qui permettent tous deux de lire des étiquettes RFID,
- chaque segment de base (121, 122, 123, 124) du cadre de montage (1) se compose d'une poutre profilée (120) et chaque support vertical (14) est également composé d'une poutre profilée (140), lesdites poutres profilées (120, 140) ayant des profilés (12a, 14a) constitués d'une base de profilé (12c, 14c) munie sur les deux côtés d'ailes de profilé (12d, 14d) dirigées à l'opposé de ladite base de profilé (12c, 14c), chaque aile de profilé (12d, 14d) s'étendant dans une direction transversale à celle de ladite base de profilé,
- chaque élément de cloison (31) de chacune des cloisons (3) a son extrémité inférieure montée dans le profilé (12c) de la base (12) du cadre de montage (1) et, en outre, chaque cloison (3) a les deux faces d'extrémité (31a, 31a) de celle-ci insérées dans le profilé (14a) du support vertical (14) du cadre de montage (1),
- entre au moins un segment de base (121, 122, 123, 124) et une extrémité inférieure de l'élément de cloison (31) montée sur celui-ci, est inséré un joint de suppression des interférences aux fréquences radioélectriques (7), lequel est un joint CEM, qui s'étend de façon co-directionnelle avec la base de profilé (12c) d'une poutre profilée (120) comprenant ledit segment de base (121, 122, 123, 124), par lequel entre au moins une face latérale verticale (31e) adjacente à au moins une face d'extrémité (31a) d'un élément de cloison (31) monté sur ledit segment de base (121, 122, 123, 124) et l'aile de profilé (14d) du profilé (14a) de la poutre profilée (140) comprenant le support vertical (14) monté sur ce même segment de base (121, 122, 123, 124) est également inséré un joint de suppression des interférences aux fréquences radioélectriques (7), lequel est un joint CEM, qui s'étend de façon co-directionnelle avec le profilé (14c) de la poutre profilée (140) comprenant ledit support vertical (14), tel que le joint de suppression des interférences aux fréquences radioélectriques (7), lequel est un joint CEM, s'étend de manière sensiblement continue du segment de base (121, 122, 123, 124) jusqu'à l'aile de profilé (14d) d'au moins un support vertical (14) .

2. Cabine de lecture (100) qui renferme des étiquettes RFID selon la revendication 1, dans laquelle l'au moins une porte (5) comporte un élément de porte ainsi qu'un dormant de porte (51) qui entoure l'élément de porte, **caractérisée en ce que** le dormant de porte (51) a sa pièce inférieure (51a) insérée dans le profilé (12a) d'un segment de base (121, 122, 123, 124) de la base (12) du cadre de fixation (1), et **en ce que** le dormant de porte (51) a chaque pièce latérale (51b) de celui-ci insérée dans le profilé (14a) d'un support vertical (14) du cadre de fixation (1), par lequel au moins un joint CEM allongé (7) est installé respectivement entre la pièce inférieure (51a) du dormant de porte (51) et le profilé (12a) du segment de base (121, 122, 123, 124), ainsi qu'au moins un joint allongé de suppression des interférences aux fréquences radioélectriques (7) est également installé entre chaque pièce latérale (51b) du dormant de porte (51) et le profilé (14a) du support vertical (14).

3. Cabine de lecture (100) qui renferme des étiquettes RFID selon la revendication 1,
**caractérisée en ce que** la porte (5) est une porte coulissante qui est insérée dans le profilé d'un segment de base (121, 122, 123, 124) de la base (12) du cadre de montage (1).

4. Cabine de lecture (100) qui renferme des étiquettes RFID selon l'une des revendications précédentes, **caractérisée en ce que** le cadre de montage (1) comprend en outre un support supérieur (13) co-directionnel avec la base (12) du cadre de montage et associé à une extrémité supérieure des supports verticaux (14), et ledit support supérieur (13) est constituée d'une poutre profilée (130), le support supérieur (13) dont le profilé (13a) se compose d'une base de profilé (13c) qui est munie sur les deux côtés d'ailes de profilé (13b) dirigées à l'opposé de la base de profilé (13c), chacune dans une direction transversale à celle de ladite base de profilé (13c), par lequel
- chaque élément de cloison (31) de chacune des cloisons (3) a son extrémité supérieure insérée dans le profilé (13c) du support supérieur (13) du cadre de montage (1), et
- entre au moins une aile de profilé (13d) du support supérieur (13) et une extrémité supérieure de l'élément de cloison (31) est installé un joint de suppression des interférences aux fréquences radioélectriques (7), qui est un joint CEM, qui s'étend de manière co-directionnelle avec la base (13c) de profilé de la poutre profilée.

5. Cabine de lecture (100) qui renferme des étiquettes RFID selon l'une des revendications précédentes, **caractérisée en ce que**
- le cadre de montage comprend en outre un support de dormant de porte horizontal (15), associé à une section centrale ou à l'extrémité supérieure des supports verticaux (14), lequel support du dormant de porte (15) étant constitué d'une poutre profilée (150) dont le profilé se compose d'une base de profilé munie sur les deux côtés de celle-ci d'ailes de profilé dirigées à l'opposé de la base de profilé, chacune s'étendant dans une direction transversale à celle de ladite base de profilé, par lequel
- le support de dormant de porte (15) a au moins une de ses ailes de profilé équipée d'un joint de suppression des interférences aux fréquences radioélectriques (7), lequel est un joint CEM, qui s'étend de manière co-directionnelle avec la base de profilé, et
- la partie supérieure du dormant de porte est insérée dans un profilé du support de dormant de porte (15) du cadre de montage (1) de sorte que le joint de suppression des interférences aux fréquences radioélectriques (7) susmentionné, lequel est un joint CEM, est également supporté sur la partie supérieure du dormant de porte.

6. Cabine de lecture (100) qui renferme des étiquettes RFID selon la revendication 4 **caractérisée en ce qu'**un premier joint de suppression des interférences aux fréquences radioélectriques (7) lequel est un joint CEM s'étend de manière continue d'une aile de profilé (12d) du profilé (12a) dans la base (12) du cadre de montage (1) à une aile de profilé (14d) du profilé (14a) dans deux supports verticaux (14) associés à celui-ci, et à une aile de profilé (13d) du profilé (13a) dans le
support supérieur (13).

7. Cabine de lecture (100) qui renferme des étiquettes RFID selon la revendication 5, **caractérisée en ce qu'**un second joint de suppression des interférences aux fréquences radioélectriques (7) lequel est un joint CEM s'étend de manière continue d'une aile de profilé (12d) du profilé (12a) dans la base (12) du cadre de montage (1) jusqu'à une aile de profilé (14d) du profilé (14a) dans un support vertical (14) et plus loin jusqu'à une aile de profilé du profilé dans le support de dormant de porte (15).

8. Cabine de lecture (100) qui renferme des étiquettes RFID selon l'une quelconque des revendications précédentes, **caractérisée en ce que** le support vertical (14) se compose de deux poutres profilées (140) en contact l'une avec l'autre.

9. Cabine de lecture (100) qui renferme des étiquettes RFID selon la revendication 8, **caractérisée en ce que** les poutres profilées (140) ont les bouches des profilés verticaux (14a, 14a) de celles-ci qui s'ouvrent dans des directions opposées.

10. Cabine de lecture (100) qui renferme des étiquettes RFID selon la revendication 8, **caractérisée en ce que** les poutres profilées (140) ont les bouches des profilés verticaux (14a) de celles-ci orientées selon un angle de 90 degrés l'une par rapport à l'autre.

11. Cabine de lecture (100) qui renferme des étiquettes RFID selon l'une quelconque des revendications 8 à 10, **caractérisée en ce que** les poutres profilées (140) sont fixées l'une à l'autre ou intégrées pour une seule pièce.

12. Cabine de lecture (100) qui renferme des étiquettes RFID selon l'une quelconque des revendications précédentes, **caractérisée en ce que** le profilé (14a) de chacun de la pluralité des supports verticaux (14) s'ouvre dans le sens longitudinal du segment de base (121, 122, 122, 123) de la base (12) du cadre de montage (1) .

13. Cabine de lecture (100) qui renferme des étiquettes RFID selon la revendication 4, **caractérisée en ce que** chacun de la pluralité des supports verticaux (14) comprend une poutre profilée (140), munie à son extrémité inférieure et/ou supérieure d'un adaptateur (8) pour installer ledit support vertical (14) dans le profilé (12a) d'un segment de base de la base (12) du cadre de montage et/ou dans le profilé (13a) du support supérieur (13) .

14. Cabine de lecture (100) qui renferme des étiquettes RFID selon la revendication 13, **caractérisée en ce que** le joint (7) dans le sens de la longueur de chacun de la pluralité des supports verticaux (14) s'étend jusqu'à un profilé (12a) de la base (12) et/ou du profilé (13a) du support supérieur (13).

15. Cabine de lecture (100) qui renferme les étiquettes RFID, ladite cabine de lecture ayant un plafond (2), un plancher (4), au moins une porte (5), ainsi que des cloisons (3) entourant la cabine de lecture (100) et comportant une pluralité d'éléments de cloison reliés entre eux (31), ainsi qu'un cadre de montage (1) pour les cloisons (3) et l'au moins une porte (5), ainsi que des moyens pour lire des étiquettes RFID dans la cabine de lecture (100), dans laquelle la cabine de lecture a
- son cadre de montage (1) comprenant une base horizontale (12) s'étendant autour d'un intérieur (T) de la cabine de lecture (100) et constitué d'une pluralité de segments de base reliés entre eux, ladite base étant munie d'une pluralité de supports verticaux (14),
- chaque segment de base ainsi que le support vertical (14) du cadre de montage (1) étant composé respectivement d'une poutre munie d'une âme (12g, 14g) qui est dirigée vers le haut à partir du plan horizontal de la poutre ou latéralement à partir du plan vertical de la poutre et qui s'étend dans une direction longitudinale de la poutre,
- l'extrémité inférieure ainsi que les deux faces d'extrémité (31a) de chacun des éléments de cloison reliés entre eux (31) équipés d'un profilé allongé (311) qui se compose d'une base de profilé (31c) munie sur les deux côtés de celui-ci d'ailes de profilé (31d) dirigées à l'opposé de la base du profilé, chacune s'étendant dans une direction transversale à celle de ladite base du profilé, par laquelle
chacune des cloisons (3) a le profilé (311) d'une extrémité inférieure de son élément de cloison (31) et le profilé (311) de chaque face d'extrémité (31a) de son élément de cloison (31) monté sur l'âme (12g) du cadre de montage,
entre le profilé d'extrémité inférieure (311) de chacun des éléments de cloison reliés entre eux (31) et l'âme (12g) d'un segment de base (121, 122, 123, 124) du cadre de montage (1) est monté au moins un joint de suppression des interférences aux fréquences radioélectriques (7), lequel est un joint CEM (71), qui s'étend de façon co-directionnelle avec une base de profilé (31c) dudit profilé (311), et
entre le profilé (311) de chaque face d'extrémité (31) et la bande (14g) d'un support vertical respectif (14) est également monté au moins un joint de suppression des interférences aux fréquences radioélectriques (7), lequel est un joint CEM (7a), qui s'étend dans la direction longitudinale du support vertical (14),
des moyens de lecture (6) pour des étiquettes RFID comprennent une antenne ainsi qu'un système de traitement des données, qui permettent tous deux de lire des étiquettes RFID.

16. Cabine de lecture (100) qui renferme des étiquettes RFID selon la revendication 15, dans laquelle au moins une porte (5) comporte un élément de porte ainsi qu'un dormant de porte (51) entourant l'élément de porte, **caractérisée en ce que** le dormant de porte (51) a sur sa pièce inférieure (51a) et sur chaque pièce latérale (51b, 51b) du dormant de porte (51) un profilé, qui se compose d'une base de profilé dont les deux côtés de celle-ci, sont munis d'ailes de profilé dirigées à l'opposé de la base de profilé, chacune s'étendant dans une direction transversale à celle de ladite base de profilé, et
au moins une des ailes de profilé d'un profilé dans la pièce inférieure (51a) du dormant de porte (51) et au moins une des ailes de profilé de chaque pièce latérale (51b, 51b) de celui-ci sont équipées d'un joint de suppression des interférences aux fréquences radioélectriques (7), lequel est un joint CEM, qui s'étend de manière co-directionnelle avec ladite base de profilé, par lequel chaque pièce latérale (51b, 51b) du dormant de porte (51) est montée sur une âme (41g) du support vertical (14) du cadre de montage de sorte que l'au moins un joint CEM précité (7) est également en contact avec l'âme (14g) des supports verticaux (14) du cadre de montage,
la partie inférieure (51a) du dormant de porte (51) est montée sur un segment de base (121, 122, 123, 124) de manière à ce que l'au moins un joint CEM précité (7) soit également en contact avec l'âme (12g) du segment de base de la base (12) du cadre de montage.

17. Cabine de lecture (100) qui renferme des étiquettes RFID selon la revendication 15 ou 16, **caractérisée en ce que** la porte (5) est une porte coulissante, qui est montée sur une âme (12g) à partir d'un segment de base (121 122, 123, 124) de la base (12) du cadre de montage (1) .

18. Cabine de lecture (100) qui renferme des étiquettes RFID selon l'une quelconque des revendications précédentes 15 à 17, **caractérisée en ce que**
- le cadre de montage (1) comprend en outre un support supérieur (13), qui est co-directionnel avec la base (12) du cadre de montage (1) et associé à une extrémité supérieure des supports verticaux (14), et ledit support supérieur (13) est constitué d'une poutre qui comporte une âme (13g) dirigée vers le bas à partir du plan horizontal de la poutre et s'étendant de manière co-directionnelle avec une direction longitudinale du support supérieur (13), par lequel la cloison (3) a une extrémité supérieure de ses éléments de cloison (31) et/ou le dormant de porte (51) a une extrémité supérieure de sa partie supérieure munie d'un profilé allongé (311), qui se compose d'une base de profilé munie sur les deux côtés de celle-ci d'ailes de profilé dirigées à l'opposé de la base de profilé, chacune s'étendant dans une direction transversale à celle de ladite base de profilé,
- chaque élément de cloison (31) de la cloison (3) a son profilé d'extrémité supérieur (311) et/ou le dormant de porte (51) a le profilé d'extrémité supérieur (311) de sa partie supérieure monté sur ladite âme (13g) du support supérieur (13) du cadre de montage (1),
- entre au moins une aile de profilé du profilé d'extrémité supérieur de chaque élément de cloison (31) de la cloison (3) et sur l'âme (13g) du support supérieur (13) est monté un joint allongé de suppression des interférences aux fréquences radioélectriques (7), lequel est un joint CEM (7a), qui s'étend de manière co-directionnelle avec le profilé d'extrémité supérieure (311) dudit élément de cloison (31).

19. Cabine de lecture (100) qui renferme des étiquettes RFID selon la revendication précédente 18,
**caractérisée en ce que** le joint CEM (7) s'étend de manière continue de l'âme (12g) d'un segment de base de la base (12) du cadre de montage (1) jusqu'à l'âme (14g) d'un support vertical (14) associé par deux segments de base, à la bande (13g) du support supérieur (13).

20. Cabine de lecture (100) qui renferme des étiquettes RFID selon la revendication 19, **caractérisée en ce que** le joint CEM (7) s'étend de manière continue d'une face d'extrémité inférieure de la cloison (31) à chaque face latérale de la cloison (31).

21. Cabine de lecture (100) qui renferme des étiquettes RFID selon la revendication 18 ou 19, **caractérisée en ce que** le joint CEM (7) s'étend de manière continue de l'âme (12g) d'un segment de base de la base (12) du cadre de montage (1) jusqu'à l'âme (14g) d'un support vertical (14), et plus loin jusqu'à l'âme d'un support (15) de dormant de porte.

22. Cabine de lecture (100) qui renferme des étiquettes RFID selon l'une quelconque des revendications précédentes 15 à 21, **caractérisée en ce que** deux supports verticaux (14) sont couplés l'un à l'autre de manière à ce que les âmes (14g) de ceux-ci soient orientées dans des directions opposées.

23. Cabine de lecture (100) qui renferme des étiquettes RFID selon l'une quelconque des revendications précédentes 15 à 21, **caractérisée en ce que** deux supports verticaux (14) sont couplés l'un à l'autre de manière à ce que les âmes (14g) de ceux-ci soient orientées selon un angle de 90 degrés l'une par rapport à l'autre.

24. Cabine de lecture (100) qui renferme des étiquettes RFID selon l'une quelconque des revendications précédentes, **caractérisée en ce qu'**un cadre de montage auxiliaire (9) est installé sous la base (12) du cadre de montage pour ajuster la direction de la base (12) du cadre de montage par rapport au sol ou aux fondations d'un bâtiment.

25. Cabine de lecture (100) qui renferme des étiquettes RFID selon l'une quelconque des revendications précédentes 1 à 24, dans laquelle le joint de suppression des interférences aux fréquences radioélectriques est un joint métallique.

26. Cabine de lecture (100) qui renferme des étiquettes RFID selon l'une quelconque des revendications précédentes 1 à 25, dans laquelle le joint de suppression des interférences aux fréquences radioélectriques est un joint CEM en métal tel que l'aluminium, et conçu avec des formes à verrouillage de forme mutuel pour les segments de base (121, 122, 123, 124) de la base (12) du cadre de montage et pour les supports verticaux (14) du cadre de montage, ainsi que pour les éléments de cloison de la cloison à coupler à celle-ci.

27. Cabine de lecture (100) qui renferme des étiquettes RFID selon l'une quelconque des revendications précédentes 1 à 26, qui se trouve dans un conteneur transportable.

28. Cabine de lecture (100) qui renferme des étiquettes RFID selon l'une quelconque des revendications précédentes 1 à 27, qui est située à proximité d'un espace ou atelier de stockage, ledit lieu de stockage ou atelier servant au transport d'objets munis d'étiquettes RFID.

29. Utilisation d'une cabine de lecture (100) qui renferme des étiquettes RFID selon l'une quelconque des revendications précédentes 1 à 28 pour contrôler les entrées et les sorties des personnes en possession d'étiquettes RFID.
